# EUROPEAN PATENT APPLICATION

(11) **EP 4 404 716 A1**
(43) Date of publication of application: **24.07.2024**
(21) Application number: 24150577.5
(22) Date of filing: 05.01.2024
(51) Int. Cl.: H10K 59/122, H10K 59/12, H10K 59/35, H10K 59/80, H10K 50/844, H10K 50/824

(54) **DISPLAY DEVICE AND MANUFACTURING METHOD**

(30) Priority: 06.01.2023 KR 20230002032
(71) Applicant: Samsung Display Co., Ltd, Gyeonggi-do (KR)
(72) Inventor: CHANG, Chongsup, Yongin-si (KR); BAEK, Youngseok, Yongin-si (KR); YOO, Inkyung, Yongin-si (KR); LEE, Yonghan, Yongin-si (KR)
(74) Representative: Marks & Clerk LLP

(57) **Abstract**

A display device including a first lower electrode disposed on a base layer, an insulating film disposed on the base layer, a conductive barrier rib disposed on the insulating film and having a first opening defined therein and corresponding to a light-emitting region, a first light-emitting pattern disposed on the first lower electrode inside the first opening, a first upper electrode disposed on the first light-emitting pattern and contacting an inner side surface of the conductive barrier rib defining the first opening, and a first inorganic encapsulation pattern, disposed in the first opening, and contacting the inner side surface of the conductive barrier rib, wherein a central portion of an upper surface of the first inorganic encapsulation pattern and a peripheral portion surrounding the central portion of the upper surface of the first inorganic encapsulation pattern may form a step difference.

## Description

### BACKGROUND

### 1. Technical Field

The disclosure relates to a display device with improved reliability and a method for manufacturing the same.

### 2. Description of the Related Art

Multimedia electronic devices such as televisions, mobile phones, tablets, computers, navigation systems, and game machines may have a display device for displaying images.

The display device may include a light-emitting element and a pixel circuit for driving the light-emitting element. The light-emitting elements included in the display device may emit light and generate an image according to a voltage applied from the pixel circuit.

In order to improve the reliability of the display device, research is being conducted on a patterning method for the light-emitting element, and recently, research is being conducted on a method of patterning a commonly provided light-emitting material for each pixel by using an open mask.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a display device with improved reliability.

The disclosure also provides a display device with a simplified process.

An embodiment provides a display device that includes a base layer including a light-emitting region, and a non-light-emitting region, a first lower electrode disposed on the base layer, an insulating film disposed on the base layer and including a first light-emitting opening and exposing at least a portion of an upper surface of the first lower electrode, a conductive barrier rib disposed on the insulating film and having a first opening defined therein and corresponding to the light-emitting region, a first light-emitting pattern disposed on the first lower electrode and disposed inside the first opening, a first upper electrode disposed on the first light-emitting pattern and contacting an inner side surface of the conductive barrier rib defining the first opening, and a first inorganic encapsulation pattern covering the first upper electrode, disposed in the first opening, and contacting the inner side surface of the conductive barrier rib defining the first opening, wherein a central portion of an upper surface of the first inorganic encapsulation pattern and a peripheral portion surrounding the central portion of the upper surface of the first inorganic encapsulation pattern form a step difference.

In an embodiment, the central portion may be recessed toward the base layer.

In an embodiment, the central portion may protrude toward an outside of the display device.

In an embodiment, the display device may further include a sacrificial pattern disposed on an outer side region of the first lower electrode and disposed between the first lower electrode and the insulating film.

In an embodiment, the conductive barrier rib may include a first conductive layer having a first conductivity, and a second conductive layer disposed on the first conductive layer and having a second conductivity lower than the first conductivity. A thickness of the first conductive layer may be greater than a thickness of the second conductive layer.

In an embodiment, an inner side surface of the first conductive layer may define a first region of the first opening, an inner side surface of the second conductive layer may define a second region of the first opening, wherein, in a cross sectional view, the inner side surface of the second conductive layer defining the second region may be closer to a center of the first lower electrode than the inner side surface of the first conductive layer defining the first region.

In an embodiment, the display device may further include an organic pattern disposed on the first inorganic encapsulation pattern, overlapping the central portion in a plan view, and non-overlapping the peripheral portion in a plan view.

In an embodiment, the display device may further include an organic encapsulation film disposed on the first inorganic encapsulation pattern and the organic pattern, wherein the organic encapsulation film may include a material different from a material of the organic pattern.

In an embodiment, the display device may further include a second lower electrode disposed on a same layer as a layer on which the first lower electrode is disposed and spaced apart from the first lower electrode, a second light-emitting pattern disposed on the second lower electrode and spaced apart from the first light-emitting pattern, a second upper electrode disposed on the second light-emitting pattern and spaced apart from the first upper electrode, and a second inorganic encapsulation pattern covering the second upper electrode and spaced apart from the first inorganic encapsulation pattern. A second light-emitting opening exposing a portion of an upper surface of the second lower electrode may be defined in the insulating film, a second opening spaced apart from the first opening may be defined in the conductive barrier rib, the second light-emitting pattern may be disposed in the second opening, the second upper electrode may be disposed in the second opening and contact an inner side surface of the conductive barrier rib defining the second opening, and the second inorganic encapsulation pattern may be disposed in the second opening and contact the inner side surface of the conductive barrier rib defining the second opening.

In an embodiment, a minimum thickness of the first inorganic encapsulation pattern may be greater than a minimum thickness of the second inorganic encapsulation pattern.

In an embodiment, a method for manufacturing a display device includes providing a preliminary display panel including a base layer including a light-emitting region and a non-light-emitting region, a first lower electrode, an insulating film, and a conductive barrier rib including a first opening, forming a first light-emitting pattern disposed on the first lower electrode inside the first opening and a dummy first light-emitting pattern disposed on an upper surface of the conductive barrier rib, forming a first upper electrode disposed on the first light-emitting pattern and disposed inside the first opening and contacting an inner side surface of the conductive barrier rib defining the first opening and a dummy first upper electrode disposed on the dummy first light-emitting pattern, forming a first inorganic encapsulation layer covering the first upper electrode and the dummy first upper electrode, overlapping the light-emitting region and the non-light-emitting region in a plan view, and defining a first cavity in the light-emitting region, forming a first organic layer including a first filling portion disposed in the first cavity and a first flat portion disposed on the first inorganic encapsulation layer, removing the first flat portion, forming a first inorganic encapsulation pattern in the first opening by removing at least a portion of the first filling portion and at least a portion of the first inorganic encapsulation layer, and removing the dummy first light-emitting pattern and the dummy first upper electrode.

In an embodiment, the forming of the first inorganic encapsulation pattern and the removing of the dummy first light-emitting pattern and the dummy first upper electrode may be performed through a same etching step.

In an embodiment, the removing of the first flat portion may be performed by an ashing method.

In an embodiment, the forming of the first inorganic encapsulation pattern may be performed by a dry etching method.

In an embodiment, an etch rate of the first organic layer may be higher than an etch rate of the first inorganic encapsulation layer.

In an embodiment, the providing of the preliminary display panel may include preparing the base layer, a first lower electrode disposed on the base layer, an insulating layer covering the first lower electrode, and a conductive barrier rib layer disposed on the insulating layer, forming a preliminary first opening corresponding to the light-emitting region in the conductive barrier rib layer, forming a first light-emitting opening exposing at least a portion of the upper surface of the first lower electrode in the insulating film, and forming a first opening from the preliminary first opening of the conductive barrier rib layer so that a conductive barrier rib is formed from the conductive barrier rib layer.

In an embodiment, the conductive barrier rib layer may include a first conductive layer having a first conductivity, and a second conductive layer disposed on the first conductive layer and having a second conductivity lower than the first conductivity, the first conductive layer and the second conductive layer may be dry-etched in the forming of the preliminary first opening, the first conductive layer and the second conductive layer may be wet-etched in the forming of the first opening, and in a cross sectional view, the inner side surface of the second conductive layer defining a second region of the first opening may be closer to a center of the first lower electrode than the inner side surface of the first conductive layer defining a first region of the first opening.

In an embodiment, the preliminary display panel may further include a sacrificial pattern disposed on the first lower electrode in the providing of the preliminary display panel, and a lower opening exposing a portion of the upper surface of the first lower electrode may be formed in the sacrificial pattern in the forming of the first opening.

In an embodiment, a central portion of an upper surface of the first inorganic encapsulation pattern and a peripheral portion surrounding the central portion of the upper surface of the first inorganic encapsulation pattern may form a step difference.

In an embodiment, the preliminary display panel may further include a second lower electrode spaced apart from the first lower electrode, a second opening may be defined in the conductive barrier rib, and the method may further include forming a second light-emitting pattern disposed on the second lower electrode inside the second opening and a dummy second light-emitting pattern disposed on an upper surface of the conductive barrier rib inside the first opening, forming a second upper electrode disposed on the second light-emitting pattern inside the second opening and contacting the inner side surface of the conductive barrier rib defining the second opening and a dummy second upper electrode disposed on the dummy second light-emitting pattern, forming a second inorganic encapsulation layer covering the second upper electrode and the dummy second upper electrode, overlapping the light-emitting region and the non-light-emitting region in a plan view, and defining a second cavity in the light-emitting region, forming a second organic layer including a second filling portion disposed in the second cavity and a second flat portion disposed on the second inorganic encapsulation layer, removing the second flat portion, forming a second inorganic encapsulation pattern in the second opening by removing at least a portion of the second filling portion and a portion of the second inorganic encapsulation layer, and removing the dummy second light-emitting pattern and the dummy second upper electrode.

At least some of the above and other features of the invention are set out in the claims.

### BRIEF DESCRIPTION OF THE DRAWINGS

The accompanying drawings are included to provide a further understanding of the disclosure, and are incorporated in and constitute a part of this specification. The drawings illustrate embodiments and, together with the description, serve to explain principles of the disclosure. In the drawings:
FIG. 1A is a schematic perspective view of a display device according to an embodiment;
FIG. 1B is an exploded schematic perspective view of the display device according to an embodiment;
FIG. 2 is a schematic cross-sectional view of a display module according to an embodiment;
FIG. 3 is a schematic plan view of a display panel according to an embodiment;
FIG. 4 is an enlarged schematic plan view of a portion of a display region of the display panel according to an embodiment;
FIG. 5A is a schematic cross-sectional view of the display panel according to an embodiment, which is taken along line I-I' of FIG. 4;
FIG. 5B is a schematic cross-sectional view of the display panel according to an embodiment, which is taken along line II-II' of FIG. 4;
FIG. 6 is a schematic cross-sectional view of the display panel according to an embodiment, which is taken along line I-I' of FIG. 4;
FIG. 7 is a schematic cross-sectional view of the display panel according to an embodiment, which is taken along line I-I' of FIG. 4;
FIGS. 8A to 8L are schematic cross-sectional views illustrating some steps of a method of manufacturing the display device according to an embodiment;
FIGS. 9A to 9G are schematic cross-sectional views illustrating some steps of the method of manufacturing the display device according to an embodiment;
FIGS. 10A to 10G are schematic cross-sectional views illustrating some steps of the method of manufacturing the display device according to an embodiment;
FIGS. 11A and 11B are schematic cross-sectional views illustrating some steps of the method of manufacturing the display device according to an embodiment; and
FIGS. 12A and 12B are schematic cross-sectional views illustrating some steps of the method of manufacturing the display device according to an embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In this specification, it will be understood that when an element (or region, layer, portion, etc.) is referred to as being "on", "connected to" or "coupled to" another element, it can be directly on, connected or coupled to the other element, or intervening elements may be present.

Like reference numerals refer to like elements throughout. In addition, in the drawings, the thicknesses, ratios, and dimensions of elements may be exaggerated for effective description of the technical contents.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

It will be understood that, although the terms first, second, etc. may be used herein to describe various elements, these elements should not be limited by these terms. These terms are only used to distinguish one element from another element. For example, a first element could be termed a second element without departing from the scope of the disclosure. Similarly, the second element may also be referred to as the first element. Terms of a singular form may include the plural form unless otherwise specified.

Relative terms, such as "below", "lower", "above", "upper" and the like, are used herein for ease of description to describe one element's relation to another element(s) as illustrated in the figures. The above terms are relative concepts and are described based on the directions indicated in the drawings.

It will be understood that the terms "comprise," "include," and/or "have", when used in this specification, specify the presence of stated features, integers, steps, operations, elements, components and/or groups thereof, but do not preclude the presence or addition of one or more other features, integers, steps, operations, elements, components, and/or groups thereof.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as "not overlapping" or to "not overlap" another element, this may include that the elements are spaced apart from each other, offset from each other, or set aside from each other or any other suitable term as would be appreciated and understood by those of ordinary skill in the art.

It will be understood that the terms "connected to" or "coupled to" may include a physical or electrical connection or coupling.

"About" or "approximately" or "substantially" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

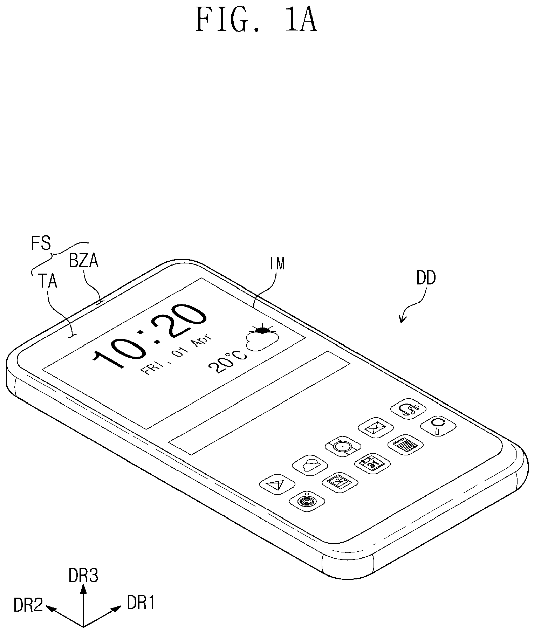

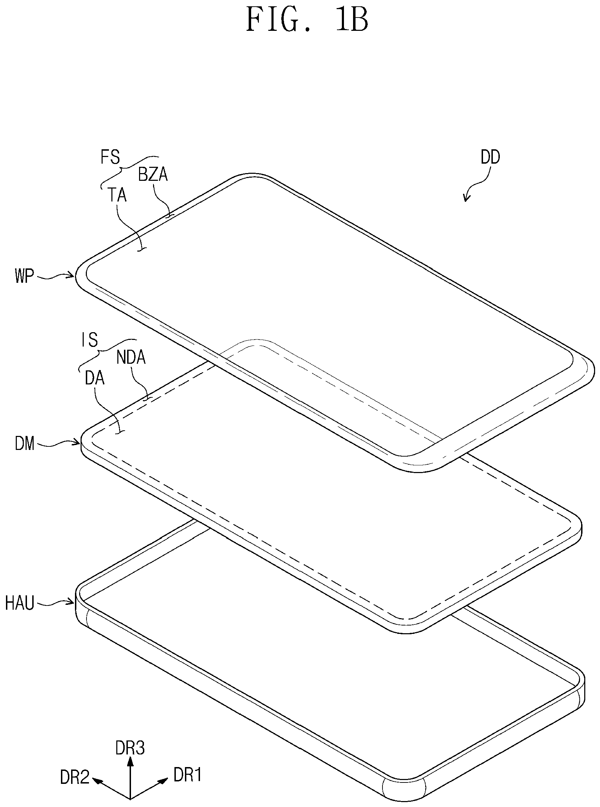

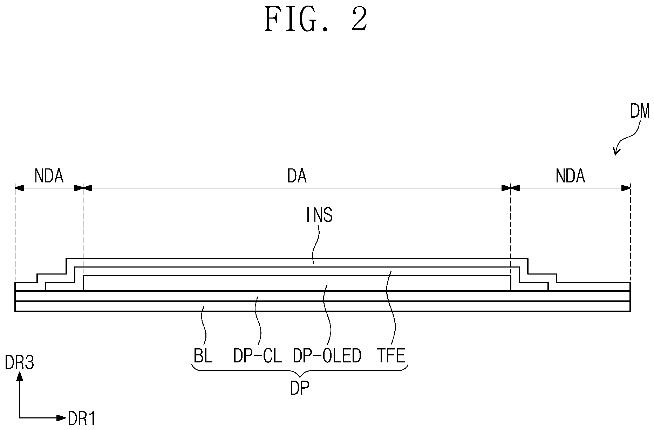

FIG. 1A is a schematic perspective view of a display device DD according to an embodiment. FIG. 1B is an exploded schematic perspective view of the display device DD according to an embodiment. FIG. 2 is a schematic cross-sectional view of a display module DM according to an embodiment.

In an embodiment, the display device DD may be a large electronic device such as a television, a monitor, or an external billboard. In addition, the display device DD may be a small or medium-sized electronic device such as a personal computer, a notebook computer, a personal digital terminal, a car navigation system, a game machine, a smart phone, a tablet, and/or a camera. These are only presented as examples, and the display device DD may be applied to other electronic devices as long as they do not depart from the principles of the disclosure. In an embodiment, a smart phone is illustrated as an example of the display device DD.

Referring to FIGS. 1A, 1B, and 2, the display device DD may display an image IM toward a third direction DR3 on a display surface FS parallel to each of a first direction DR1 and a second direction DR2. The image IM may include a still image as well as a dynamic image. In FIG. 1, a watch window and icons are illustrated as an example of the image IM. The display surface FS on which the image IM is displayed may correspond to the front surface of the display device DD.

In an embodiment, the front surface (or upper surface) and the rear surface (or lower surface) of each member may be defined based on a direction in which the image IM is displayed. The front surface and the rear surface face each other in the third direction DR3, and a normal direction of each of the front surface and the rear surface may be parallel to the third direction DR3. Directions indicated by the first to third directions DR1, DR2, and DR3 are relative concepts and may be converted into other directions. In this specification, the expression "in a plan view" may mean when viewed from the third direction DR3.

As illustrated in FIG. 1B, the display device DD according to an embodiment may include a window WP, a display module DM, and a housing HAU. The window WP and the housing HAU may be coupled to each other to configure the exterior of the display device DD.

The window WP may contain an optically transparent insulating material. For example, the window WP may contain glass or plastic. The front surface of the window WP may define the display surface FS of the display device DD. The display surface FS may include a transmission region TA and a bezel region BZA. The transmission region TA may be an optically transparent region. For example, the transmission region TA may have a visible light transmittance of about 90% or more.

The bezel region BZA may have a relatively low light transmittance compared to the transmission region TA. The bezel region BZA may define the shape of the transmission region TA. The bezel region BZA may be adjacent to and surround the transmission region TA. This is illustrated as an example, and in the window WP according to an embodiment, the bezel region BZA may be omitted. The window WP may include at least one functional layer among an anti-fingerprint layer, a hard coating layer, and an anti-reflection layer, and is not limited to any one particular embodiment.

The display module DM may be disposed below the window WP. The display module DM may be a component that substantially generates an image IM. The image IM generated by the display module DM may be displayed on the display surface IS of the display module DM and may be visually recognized by a user from the outside through the transmission region TA.

The display module DM may include a display region DA and a non-display region NDA. The display region DA may be activated according to an electrical signal. The non-display region NDA may be adjacent to the display region DA. The non-display region NDA may surround the display region DA. The non-display region NDA may be covered (overlapped) by the bezel region BZA and may not be visible from the outside.

As illustrated in FIG. 2, the display module DM according to an embodiment may include a display panel DP and an input sensor INS. Although not separately illustrated, the display device DD (see FIG. 1B) according to an embodiment may further include a protective member disposed on the lower surface of the display panel DP or an anti-reflection member and/or a window member disposed on the upper surface of the input sensor INS.

The display panel DP may be a light-emitting display panel and is not particularly limited thereto. For example, the display panel DP may be an organic light-emitting display panel or an inorganic light-emitting display panel. A light-emitting layer in the organic light-emitting display panel may contain an organic light-emitting material. A light-emitting layer in the inorganic light-emitting display panel may contain quantum dots, quantum rods, or micro LEDs. Hereinafter, the display panel DP will be described as an organic light-emitting display panel.

The display panel DP may include a base layer BL, a circuit element layer DP-CL disposed on the base layer BL, a display element layer DP-OLED, and a thin film encapsulation layer TFE. The input sensor INS may be disposed directly on the thin film encapsulation layer TFE. In this specification, the expression "Component A is disposed directly on component B" means that no adhesive layer is disposed between component A and component B.

The base layer BL may include at least one plastic film. The base layer BL, as a flexible substrate, may include a plastic substrate, a glass substrate, a metal substrate, and/or an organic/inorganic composite material substrate. The display region DA and the non-display region NDA described with reference to FIG. 1B may be equally defined in the base layer BL.

The circuit element layer DP-CL may include at least one insulating layer and a circuit element. The insulating layer may include at least one inorganic layer and at least one organic layer. The circuit element may include signal lines, a pixel driving circuit, and the like.

The display element layer DP-OLED may include a conductive barrier rib and a light-emitting element. The light-emitting element may include a lower electrode, a light-emitting pattern, and an upper electrode.

The thin film encapsulation layer TFE may include multiple thin films. Some thin films may be disposed to improve optical efficiency, and other thin films may be disposed to protect organic light-emitting diodes.

The input sensor INS may acquire the coordinate information of an external input. The input sensor INS may have a multi-layered structure. The input sensor INS may include a single-layered or multi-layered conductive layer. The input sensor INS may include a single-layered or multi-layered insulating layer. The input sensor INS may sense an external input, for example, in a capacitive manner. In this disclosure, the operation manner of the input sensor INS is not particularly limited, and in an embodiment, the input sensor INS may sense an external input in an electromagnetic induction manner or a pressure-sensing manner. In another embodiment, the input sensor INS may be omitted.

As illustrated in FIG. 1B, the housing HAU may be coupled to the window WP. The housing HAU may be coupled to the window WP to provide a predetermined or selected inner space. The display module DM may be accommodated in the inner space.

The housing HAU may contain a material with relatively high rigidity. For example, the housing HAU may include multiple frames and/or plates made of glass, plastic, or metal, or a combination thereof. The housing HAU may stably protect the components of the display device DD accommodated in the inner space from an external impact.

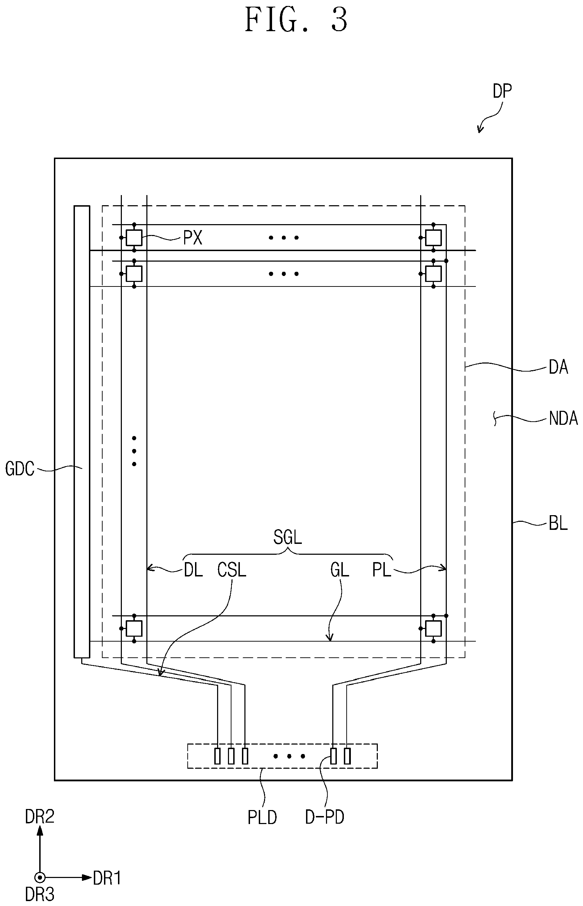

FIG. 3 is a schematic plan view of a display panel DP according to an embodiment.

Referring to FIG. 3, the display panel DP may include a base layer BL divided into a display region DA and a non-display region NDA described with reference to FIG. 2.

The display panel DP may include pixels PX disposed in the display region DA and signal lines SGL electrically connected to the pixels PX. The display panel DP may include a driving circuit GDC and a pad portion PLD disposed in the non-display region NDA.

The pixels PX may be arranged in the first and second directions DR1 and DR2. The pixels PX may include multiple pixel rows extending in the first direction DR1 and arranged in the second direction DR2 and multiple pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel of the pixels PX, and each of the data lines DL may be connected to a corresponding pixel of the pixels PX. The power line PL may be electrically connected to the pixels PX. The control signal line CSL may be connected to the driving circuit GDC to provide control signals thereto.

The driving circuit GDC may include a gate driving circuit. The gate driving circuit may generate gate signals and sequentially output the generated gate signals to the gate lines GL. The gate driving circuit may further output another control signal to the pixel driving circuit.

The pad portion PLD may be a portion to which a flexible circuit board is connected. The pad portion PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to corresponding pixels PX through the signal lines SGL. Any one of the pixel pads D-PD may be connected to the driving circuit GDC.

The pad portion PLD may further include input pads. The input pads may be pads for connecting the flexible circuit board to the input sensor INS (see FIG. 2). Without being limited thereto, however, the input pads may be disposed in the input sensor INS (see FIG. 2) and connected to the pixel pads D-PD and a separate circuit board. In another embodiment, the input sensor INS (see FIG. 2) may be omitted and may not further include the input pads.

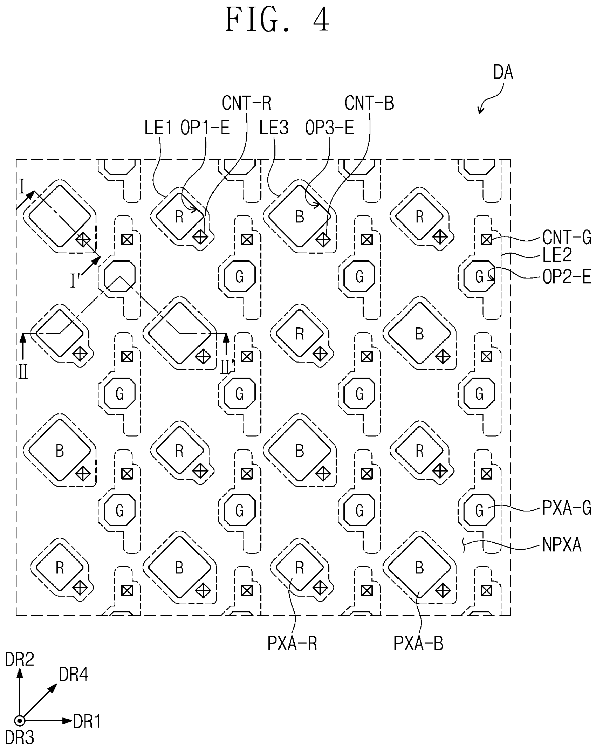

FIG. 4 is an enlarged schematic plan view of a portion of the display region DA of the display panel DP according to an embodiment. FIG. 4 illustrates a plane of the display module DM (see FIG. 1B) viewed from the display surface IS (see FIG. 1B) of the display module DM (see FIG. 1B) and shows an arrangement of light-emitting regions PXA-R (red R), PXA- G (green G), and PXA-B (blue B).

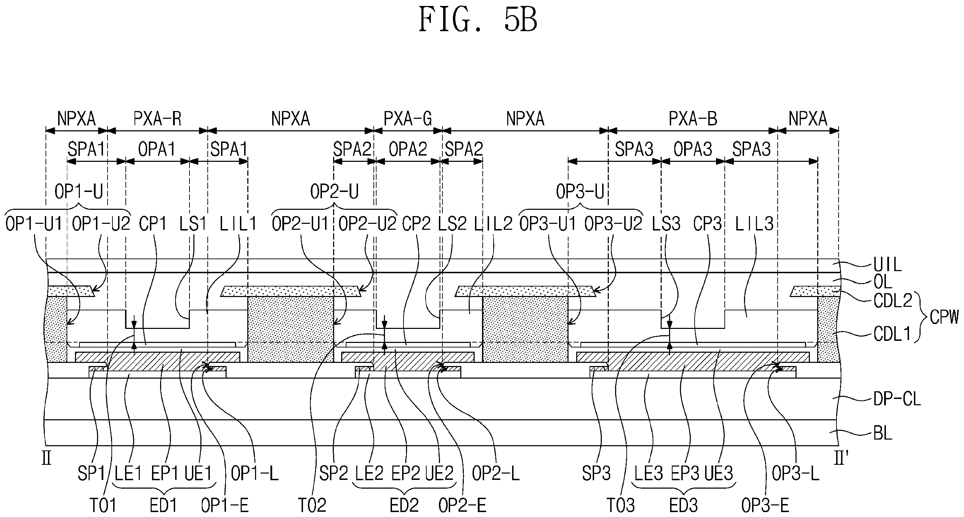

Referring to FIG. 4, the display region DA may include first to third light-emitting regions PXA-R, PXA-G, and PXA-B and a non-light-emitting region NPXA surrounding the first to third light-emitting regions PXA-R, PXA-G, and PXA-B. The first to third light-emitting regions PXA-R, PXA-G, and PXA-B may respectively correspond to regions from which light provided from light-emitting elements ED1, ED2, and ED3 (see FIG. 5B) is emitted. In FIG. 4, for convenience of explanation, only lower electrodes LE1, LE2, and LE3 among the components of the light-emitting elements ED1, ED2, and ED3 (see FIG. 5B) are illustrated as an example. The first to third light-emitting regions PXA-R, PXA-G, and PXA-B may be classified according to the color of light emitted toward the outside of the display module DM (refer to FIG. 2).

The first to third light-emitting regions PXA-R, PXA-G, and PXA-B may respectively provide first to third color lights having different colors. For example, the first color light may be red light, the second color light may be green light, and the third color light may be blue light. However, the first to third color lights are not necessarily limited to the above examples.

Each of the first to third light-emitting regions PXA-R, PXA-G, and PXA-B may be defined as a region of the upper surface of a corresponding lower electrode LE1, LE2, or LE3, which is exposed by a corresponding light-emitting opening OP1-E, OP2-E, or OP3-E. In an embodiment, the light-emitting openings OP1-E, OP2-E, and OP3-E may be defined in an insulating film ISL (see FIG. 5B) covering a portion of the lower electrodes LE1, LE2, and LE3. A detailed description of this will be provided later.

The first light-emitting region PXA-R may be defined as a region of the upper surface of the first lower electrode LE1, which is exposed by the first light-emitting opening OP1-E, the second light-emitting region PXA-G may be defined as a region of the upper surface of the second lower electrode LE2, which is exposed by the second light-emitting opening OP2-E, and the third light-emitting region PXA-B may be defined as a region of the upper surface of the third lower electrode LE3, which is exposed by the third light-emitting opening OP3-E.

The non-light-emitting region NPXA may set boundaries between the first to third light-emitting regions PXA-R, PXA-G, and PXA-B and prevent color mixing among the first to third light-emitting regions PXA-R, PXA-G, and PXA-B.

Multiple ones of each of the first to third light-emitting regions PXA-R, PXA-G, and PXA-B may be provided and they may be repeatedly arranged in a predetermined or selected arrangement form in the display region DA. For example, the first and third light-emitting regions PXA-R and PXA-B may be alternately arranged along the first direction DR1 to form a 'first group'. The second light-emitting regions PXA-G may be arranged along the first direction DR1 to form a 'second group'. Multiple ones of each of the 'first group' and the 'second group' may be provided, and the 'first groups' and the 'second groups' may be alternately arranged along the second direction DR2.

One second light-emitting region PXA-G may be disposed to be spaced apart from one first light-emitting region PXA-R or one third light-emitting region PXA-B in a fourth direction DR4. The fourth direction DR4 may be defined as a direction between the first and second directions DR1 and DR2.

FIG. 4 illustrates an arrangement form of the first to third light-emitting regions PXA-R, PXA-G, and PXA-B as an example, but the disclosure is not limited thereto and they may be arranged in various forms. In an embodiment, the first to third light-emitting regions PXA-R, PXA-G, and PXA-B may have a PENTILE^{™} arrangement form as illustrated in FIG. 4. In another embodiment, the first to third light-emitting regions PXA-R, PXA-G, and PXA-B may have a stripe arrangement form or a Diamond Pixel^{™} arrangement form.

The first to third light-emitting regions PXA-R, PXA-G, and PXA-B may have various shapes in a plan view. For example, the first to third light-emitting regions PXA-R, PXA-G, and PXA-B may have polygonal, circular, or elliptical shapes. FIG. 4 illustrates, in a plan view, the first and third light-emitting regions PXA-R and PXA-B having a quadrangular shape (or diamond shape) and the second light-emitting region PXA-G having an octagonal shape as an example.

The first to third light-emitting regions PXA-R, PXA-G, and PXA-B may have a same shape in a plan view, or at least some of them may have shapes different from the others. FIG. 4 illustrates, in a plan view, the first and third light-emitting regions PXA-R and PXA-B having a same shape and the second light-emitting region PXA-G having a shape different from those of the first and third light-emitting regions PXA-R and PXA-B as an example.

At least some of the first to third light-emitting regions PXA-R, PXA-G, and PXA-B may have areas different from each other in a plan view. In an embodiment, the area of the first light-emitting region PXA-R configured to emit red light may be larger than the area of the second light-emitting region PXA-G configured to emit green light and smaller than the area of the third light-emitting region PXA-B configured to emit blue light. However, the size relationship between the areas of the first to third light-emitting regions PXA-R, PXA-G, and PXA-B according to the color of emitted light is not limited thereto and may vary depending on the design of the display module DM (see FIG. 2). Without being limited thereto, the first to third light-emitting regions PXA-R, PXA-G, and PXA-B may have a same area in a plan view.

The shape, area, and arrangement of the first to third light-emitting regions PXA-R, PXA-G, and PXA-B of the display module DM (see FIG. 2) according to the disclosure may be designed in various ways according to the color of emitted light or the size and configuration of the display module DM (see FIG. 2), and the inventive concept is not limited to the embodiment illustrated in FIG. 4.

The lower electrodes LE1, LE2, and LE3 may be connected to the pixel driving circuits in the above-described circuit element layer DP-CL (see FIG. 2) through connection contact holes CNT-R, CNT-G, and CNT-B. The connection contact holes CNT-R, CNT-G, and CNT-B may include a first connection contact hole CNT-R, a second connection contact hole CNT-G, and a third connection contact hole CNT-B. The first connection contact hole CNT-R may be defined as a region in which the first lower electrode LE1 is connected to a corresponding pixel driving circuit, the second connection contact hole CNT-G may be defined as a region in which the second lower electrode LE2 is connected to a corresponding pixel driving circuit, and the third connection contact hole CNT-B may be defined as a region in which the third lower electrode LE3 is connected to a corresponding pixel driving circuit.

The connection contact holes CNT-R, CNT-G, and CNT-B may be respectively disposed to be spaced apart from the light-emitting regions PXA-R, PXA-G, and PXA-B defined in the lower electrodes LE1, LE2, and LE3. However, this is an example, and the connection contact holes CNT-R, CNT-G, and CNT-B may be disposed to overlap the light-emitting regions PXA-R, PXA-G, and PXA-B defined in the lower electrodes LE1, LE2, and LE3. A detailed description of the connection contact holes CNT-R, CNT-G, and CNT-B will be provided later.

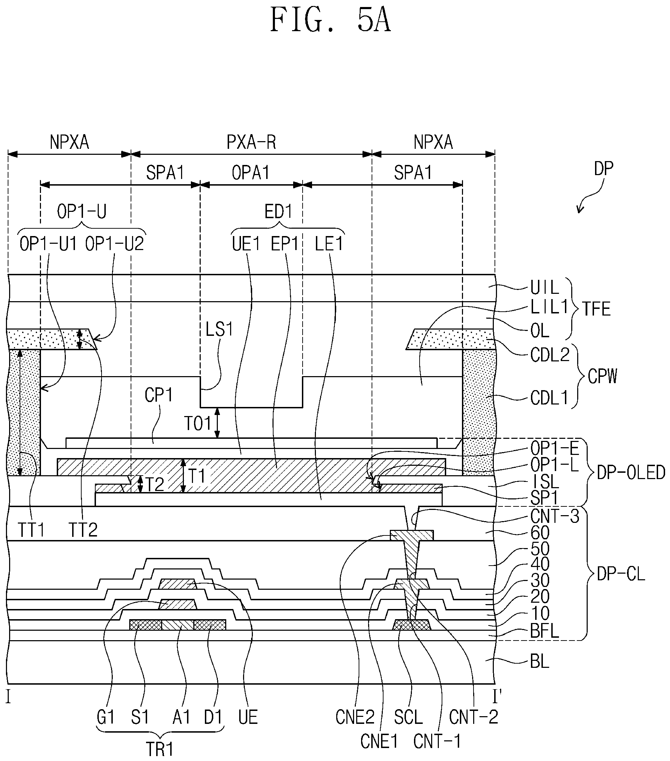

FIG. 5A is a schematic cross-sectional view of the display panel DP according to an embodiment, which is taken along line I-I' of FIG. 4. FIG. 5B is a schematic cross-sectional view of the display panel DP according to an embodiment, which is taken along line II-II' of FIG. 4.

Referring to FIGS. 5A and 5B, the display panel DP may include a base layer BL, a circuit element layer DP-CL, a display element layer DP-OLED, and a thin film encapsulation layer TFE.

The base layer BL may include a synthetic resin film. The base layer BL may include a glass substrate, a metal substrate, an organic/inorganic composite material substrate, and/or the like. The base layer BL may include light-emitting regions PXA-R, PXA-G, and PXA-B and a non-light-emitting region NPXA.

At least one inorganic layer may be disposed on the upper surface of the base layer BL. A buffer layer BFL may improve the bonding strength between the base layer BL and a semiconductor pattern. The buffer layer BFL may include a silicon oxide layer and a silicon nitride layer. The silicon oxide layer and the silicon nitride layer may be alternately stacked on each other.

The display panel DP may include multiple insulating layers, a semiconductor pattern, a conductive pattern, a signal line, and the like. An insulating layer, a semiconductor layer, and a conductive layer may be formed by coating, deposition, or the like. Hereafter, the insulating layer, the semiconductor layer, and the conductive layer may be selectively patterned through photolithography and etching processes. In this way, the semiconductor pattern, the conductive pattern, a signal line, and the like included in the circuit element layer DP-CL and the display element layer DP-OLED may be formed.

The semiconductor pattern may be disposed on the buffer layer BFL. The semiconductor pattern may contain polysilicon. Without being limited thereto, however, the semiconductor pattern may contain amorphous silicon or metal oxide.

FIG. 5A illustrates only a portion of the semiconductor pattern, and the semiconductor pattern may be further disposed in the light-emitting regions PXA-R, PXA-G, and PXA-B. The semiconductor pattern may be arranged in a specific rule across the light-emitting regions PXA-R, PXA-G, and PXA-B. The semiconductor pattern may have different electrical properties depending on whether it is doped or not. The semiconductor pattern may include a first region having a high doping concentration and a second region having a low doping concentration. The first region may be doped with an N-type dopant or a P-type dopant. A P-type transistor may include the first region doped with a P-type dopant.

The first region may have higher conductivity than the second region and substantially serve as an electrode or signal line. The second region may substantially correspond to an active (or channel) of a transistor. In other words, a portion of the semiconductor pattern may be an active of a transistor, another portion thereof may be a source or drain of a transistor, and still another portion thereof may be a conductive region.

As illustrated in FIG. 5A, a source S1, an active A1, and a drain D1 of a transistor TR1 may be formed from a semiconductor pattern. FIG. 5A illustrates a portion of a signal transmission region SCL formed from the semiconductor pattern. Although not illustrated separately, the signal transmission region SCL may be connected to the drain D1 of the transistor TR1 in a plan view.

First to sixth insulating layers 10 to 60 may be disposed on the buffer layer BFL. The first to sixth insulating layers 10 to 60 may be inorganic layers or organic layers. A gate G1 may be disposed on the first insulating layer 10. An upper electrode UE may be disposed on the second insulating layer 20. A first connection electrode CNE1 may be disposed on the third insulating layer 30. The first connection electrode CNE1 may be connected to the signal transmission region SCL through a contact hole CNT-1 passing through the first to third insulating layers 10 to 30. The fourth insulating layer 40 may be disposed on the third insulating layer 30 to cover the first connection electrode CNE1. The fifth and sixth insulating layers 50 and 60 may be disposed on the fourth insulating layer 40. In an embodiment, the fifth and sixth insulating layers 50 and 60 may be organic layers.

A second connection electrode CNE2 may be disposed on the fifth insulating layer 50. The second connection electrode CNE2 may be connected to the first connection electrode CNE1 through a contact hole CNT-2 passing through the fourth and fifth insulating layers 40 and 50.

The display element layer DP-OLED may be disposed on the circuit element layer DP-CL. According to an embodiment, the display element layer DP-OLED may include light-emitting elements ED1, ED2, and ED3, sacrificial patterns SP1, SP2, and SP3, an insulating film ISL, and a conductive barrier rib CPW.

The light-emitting elements ED1, ED2, and ED3 include a first light-emitting element ED1, a second light-emitting element ED2, and a third light-emitting element ED3. The first light-emitting element ED1 may include a first lower electrode LE1, a first light-emitting pattern EP1, and a first upper electrode UE1, the second light-emitting element ED2 may include a second lower electrode LE2, a second light-emitting pattern EP2, and a second upper electrode UE2, and the third light-emitting element ED3 may include a third lower electrode LE3, a third light-emitting pattern EP3, and a third upper electrode UE3.

The first to third lower electrodes LE1, LE2, and LE3 may be provided in multiple patterns. The second lower electrode LE2 may be disposed on the same layer as a layer on which the first lower electrode LE1 is disposed and spaced apart from the first lower electrode LE1. The third lower electrode LE3 may be disposed on the same layer as the layer on which each of the first lower electrode LE1 and the second lower electrode LE2 is disposed and spaced apart from each of the first lower electrode LE1 and the second lower electrode LE2. Hereinafter, the first lower electrode LE1 will be described, and the description of the first lower electrode LE1 may be equally applied to the second and third lower electrodes LE2 and LE3.

The first lower electrode LE1 may be disposed on the sixth insulating layer 60 of the circuit element layer DP-CL. The first lower electrode LE1 may be connected to the second connection electrode CNE2 through a connection contact hole CNT-3 defined through the sixth insulating layer 60. Through this, the first lower electrode LE1 may be electrically connected to the signal transmission region SCL through the first and second connection electrodes CNE1 and CNE2 and electrically connected to a corresponding circuit element. The connection contact holes CNT-1 and CNT-2 of FIG. 5A may correspond to the first connection contact hole CNT-R in FIG. 4.

The first lower electrode LE1 may be a (semi)transmissive electrode or a reflective electrode. In an embodiment, the first lower electrode LE1 may include a first layer and a second layer. The first layer may contain a metal material. The second layer may be disposed on the first layer and contain transparent conductive oxide.

The sacrificial patterns SP1, SP2, and SP3 may include a first sacrificial pattern SP1 disposed on the upper surface of the first lower electrode LE1, a second sacrificial pattern SP2 disposed on the upper surface of the second lower electrode LE2, and a third sacrificial pattern SP3 disposed on the upper surface of the third lower electrode LE3.

The first sacrificial pattern SP1 may be disposed on an outer side region of the first lower electrode LE1 between the first lower electrode LE1 and the insulating film ISL. The second sacrificial pattern SP2 may be disposed on an outer side region of the second lower electrode LE2 between the second lower electrode LE2 and the insulating film ISL. The third sacrificial pattern SP3 may be disposed on an outer side region of the third lower electrode LE3 between the third lower electrode LE3 and the insulating film ISL.

A first lower opening OP1-L exposing a portion of the upper surface of the first lower electrode LE1 may be defined in the first sacrificial pattern SP1, a second lower opening OP2-L exposing a portion of the upper surface of the second lower electrode LE2 may be defined in the second sacrificial pattern SP2, and a third lower opening OP3-L exposing a portion of the upper surface of the third lower electrode LE3 may be defined in the third sacrificial pattern SP3.

In an embodiment, each of the first to third sacrificial patterns SP1, SP2, and SP3 may contain amorphous transparent conductive oxide. According to the disclosure, in a process of etching the first sacrificial pattern SP1 to form the first lower opening OP1-L, it may be possible to prevent the first lower electrode LE1 from being etched and damaged. The description regarding this may be equally applied to the second sacrificial pattern SP2 and the third sacrificial pattern SP3.

The insulating film ISL may be disposed on the sixth insulating layer 60 of the circuit element layer DP-CL. The insulating film ISL may cover the first to third sacrificial patterns SP1, SP2, and SP3. For example, the insulating film ISL may cover the upper surface of each of the first to third sacrificial patterns SP1, SP2, and SP3.

First to third light-emitting openings OP1-E, OP2-E, and OP3-E may be defined in the insulating film ISL. The first light-emitting opening OP1-E may expose a portion of the upper surface of the first lower electrode LE1. The first light-emitting opening OP1-E may correspond to the first lower opening OP1-L of the first sacrificial pattern SP1. The first light-emitting opening OP1-E may correspond to the first light-emitting region PXA-R. The second light-emitting opening OP2-E may expose a portion of the upper surface of the second lower electrode LE2. The second light-emitting opening OP2-E may correspond to the second lower opening OP2-L of the second sacrificial pattern SP2. The second light-emitting opening OP2-E may correspond to the second light-emitting region PXA-G. The third light-emitting opening OP3-E may expose a portion of the upper surface of the third lower electrode LE3. The third light-emitting opening OP3-E may correspond to the third lower opening OP3-L of the third sacrificial pattern SP3. The third light-emitting opening OP3-E may correspond to the third light-emitting region PXA-B.

According to an embodiment, in a plan view, the first light-emitting opening OP1-E may overlap the first lower opening OP1-L, and the area of the first light-emitting opening OP1-E may be smaller than the area of the first lower opening OP1-L. For example, an inner side surface of the insulating film ISL defining the first light-emitting opening OP1-E may be closer to the center of the first lower electrode LE1 than an inner side surface of the first sacrificial pattern SP1 defining the first lower opening OP1-L. In this case, a portion of the insulating film ISL closer to the center of the first lower electrode LE1 than the inner side surface of the first sacrificial pattern SP1 defining the first lower opening OP1-L may define a tip portion. The descriptions of the first light-emitting opening OP1-E and the first lower opening OP1-L may be equally applied to the second light-emitting opening OP2-E, the second lower opening OP2-L, the third light-emitting opening OP3-E, and the third lower opening OP3-L.

The insulating film ISL may contain an inorganic insulating material, for example, silicon nitride (SiNx). The insulating film ISL may be disposed between the first to third lower electrodes LE1, LE2, and LE3 and the conductive barrier rib CPW so that the first to third lower electrodes LE1, LE2, LE3 and the conductive barrier rib CPW may be blocked from being electrically connected to each other.

The conductive barrier rib CPW may be disposed on the insulating film ISL. First to third upper openings OP1-U, OP2-U, and OP3-U may be defined in the conductive barrier rib CPW.

The first to third upper openings OP1-U, OP2 -U, and OP3-U may be disposed to be spaced apart from each other. The first upper opening OP1-U may correspond to the first light-emitting opening OP1-E. The first upper opening OP1-U may correspond to the first light-emitting region PXA-R. The second upper opening OP2-U may correspond to the second light-emitting opening OP2-E. The second upper opening OP2-U may correspond to the second light-emitting region PXA-G. The third upper opening OP3-U may correspond to the third light-emitting opening OP3-E. The third upper opening OP3-U may correspond to the third light-emitting region PXA-B.

In an embodiment, the conductive barrier rib CPW may include a first conductive layer CDL1 and a second conductive layer CDL2. Each of the first conductive layer CDL1 and the second conductive layer CDL2 may contain a conductive material. The first conductive layer CDL1 may be disposed on the insulating film ISL and have a first conductivity and a first thickness TT1. The second conductive layer CDL2 may be disposed on the first conductive layer CDL1, have a second conductivity lower than the first conductivity, and have a second thickness TT2 smaller than the first thickness.

An etch rate of the first conductive layer CDL1 may be higher than an etch rate of the second conductive layer CDL2. For example, the first conductive layer CDL1 may contain a material having a higher etching selectivity than the second conductive layer CDL2.

In an embodiment, each of the first and second conductive layers CDL1 and CDL2 may contain a metal material. In an embodiment, the second conductive layer CDL2 may contain a material having a reflectance lower than that of the first conductive layer CDL1. The display quality of the display panel DP may be improved by reducing reflectance on the upper surface of the second conductive layer CDL2 substantially forming an upper surface of the conductive barrier rib CPW. For example, the first conductive layer CDL1 may contain aluminium (Al), and the second conductive layer CDL2 may contain titanium (Ti). However, the material of each of the first and second conductive layers CDL1 and CDL2 is not limited to any one particular embodiment.

In an embodiment, the conductive barrier rib CPW may receive a bias voltage. Accordingly, the bias voltage may be provided to each of the first to third upper electrodes UE1, UE2, and UE3 in contact with the conductive barrier rib CPW.

As illustrated in FIG. 5A, in a cross sectional view, the first upper opening OP1-U may include a first region OP1-U1 defined by an inner side surface of the first conductive layer CDL1 and a second region OP1-U2 defined by an inner side surface of the second conductive layer CDL2. In a cross sectional view, the width of the first region OP1-U1 may be greater than that of the second region OP1-U2. In a cross sectional view, the inner side surface of the second conductive layer CDL2 defining the second region OP1-U2 may be closer to the center of the first lower electrode LE1 than the inner side surface of the first conductive layer CDL1 defining the first region OP1-U1. In the disclosure, in the conductive barrier rib CPW, a portion of the second conductive layer CDL2 closer to the center of the first lower electrode LE1 than the inner side surface of the first conductive layer CDL1 defining the first region OP1-U1 may be defined as a tip portion.

According to an embodiment, in a plan view, the area of the first region OP1-U1 of the first upper opening OP1-U defined in the first conductive layer CDL1 may be larger than the area of the first light-emitting opening OP1-E defined in the insulating film ISL, and the first conductive layer CDL1 may expose a portion of the upper surface of the insulating film ISL by the first region OP1-U1 of the first upper opening OP1-U.

Each of the first to third light-emitting patterns EP1, EP2, and EP3 may be disposed on a corresponding lower electrode among the first to third lower electrodes LE1, LE2, and LE3. The first to third light-emitting patterns EP1, EP2, and EP3 may be disposed to be spaced apart from each other. Each of the first to third light-emitting patterns EP1, EP2, and EP3 may be disposed inside a corresponding upper opening among the first to third upper openings OP1-U, OP2-U, and OP3-U. The first light-emitting pattern EP1 may be disposed on the first lower electrode LE1, the second light-emitting pattern EP2 may be disposed on the second lower electrode LE2, and the third light-emitting pattern EP3 may be disposed on the third lower electrode LE3. In an embodiment, the first light-emitting pattern EP1 may provide red light, the second light-emitting pattern EP2 may provide green light, and the third light-emitting pattern EP3 may provide blue light.

Each of the first to third light-emitting patterns EP1, EP2, and EP3 may include a light-emitting layer containing a light-emitting material. Each of the first to third light-emitting patterns EP1, EP2, and EP3 may further include a hole injection layer (HIL) and a hole transport layer (HTL) disposed between the light-emitting layer and a corresponding lower electrode among the first to third lower electrodes LE1, LE2, and LE3. Each of the first to third light-emitting patterns EP1, EP2, and EP3 may further include an electron transport layer (ETL) and an electron injection layer (EIL) disposed on the light-emitting layer.

According to the disclosure, the first to third light-emitting patterns EP1, EP2, and EP3 may be patterned by a tip portion defined in the conductive barrier rib CPW. The first light-emitting pattern EP1 may be disposed inside the first lower opening OP1-L, the first light-emitting opening OP1-E, and the first upper opening OP1-U. The first light-emitting pattern EP1 may cover a portion of the upper surface of the insulating film ISL exposed through the first upper opening OP1-U. The second light-emitting pattern EP2 may be disposed inside the second lower opening OP2-L, the second light-emitting opening OP2-E, and the second upper opening OP2-U. The second light-emitting pattern EP2 may cover a portion of the upper surface of the insulating film ISL exposed through the second upper opening OP2-U. The third light-emitting pattern EP3 may be disposed inside the third lower opening OP3-L, the third light-emitting opening OP3-E, and the third upper opening OP3-U. The third light-emitting pattern EP3 may cover a portion of the upper surface of the insulating film ISL exposed through the third upper opening OP3-U. According to an embodiment, the first to third light-emitting patterns EP1, EP2, and EP3 each may include portions measured at different thicknesses (e.g., T1, T2).

According to this aspect, multiple first light-emitting patterns EP1 may be patterned and deposited in pixel units by the tip portion defined in the conductive barrier rib CPW. For example, the multiple first light-emitting patterns EP1 may be commonly formed by using an open mask, but may be readily divided into the pixel units by the conductive barrier ribs CPW.

On the other hand, in the case that the multiple first light-emitting patterns EP1 are patterned by using a separate mask (e.g., a fine metal mask (FMM)), a support mask protruding from the barrier rib should be provided to support the separate mask. Since the separate mask is spaced apart from a base surface, on which patterning is performed, by the height of the barrier rib and the spacer, there may be a limitation in improving resolution.

As the mask comes in contact with the spacer, foreign substances may remain on the spacer after a patterning process of the multiple first light-emitting patterns EP1, or a spacer damaged by being stabbed by the mask may be provided. Accordingly, a defective display panel may be formed.

In this aspect, by patterning the multiple first light-emitting patterns EP1 without a separate mask in contact with the internal components of the display panel DP, it may be possible to provide the display panel DP with a reduced defect rate and improved reliability. In particular, in manufacturing a large-area display panel DP, a process cost may be reduced by omitting the manufacture of a large-area mask, and the display panel DP with improved reliability may be provided by not being affected by a defect occurring in the large-area mask.

FIG. 5A illustrates that the first light-emitting pattern EP1 does not come in contact with the inner side surface of the first conductive layer CDL1 defining the first region OP1-U1 of the first upper opening OP1-U as an example, but the disclosure is not limited thereto. For example, the first light-emitting pattern EP1 may come in contact with the inner side surface of the first conductive layer CDL1 defining the first upper opening OP1-U.

The above description on the first light-emitting pattern EP1 may be equally applied to the second and third light-emitting patterns EP2 and EP3.

Each of the first to third upper electrodes UE1, UE2, and UE3 may be disposed on a corresponding light-emitting pattern among the first to third light-emitting patterns EP1, EP2, and EP3. The first to third upper electrodes UE1, UE2, and UE3 may be spaced apart from each other. The first to third upper electrodes UE1, UE2, and UE3 may be respectively disposed inside the first to third upper openings OP1-U, OP2-U, and OP3-U. The first upper electrode UE1 may be disposed on the first light-emitting pattern EP1, the second upper electrode UE2 may be disposed on the second light-emitting pattern EP2, and the third upper electrode UE3 may be disposed on the third light-emitting pattern EP3. The first to third upper electrodes UE1, UE2, and UE3 may be patterned by the tip portion defined in the conductive barrier rib CPW.

In the disclosure, the first upper electrode UE1 may come in contact with the inner side surface of the first conductive layer CDL1 defining the first region OP1-U1 of the first upper opening OP1-U. Through this, the first upper electrode UE1 may be electrically connected to the conductive barrier rib CPW and receive a bias voltage through the conductive barrier rib CPW.

In the disclosure, the second upper electrode UE2 may come in contact with the inner side surface of the first conductive layer CDL1 defining the first region OP2-U1 of the second upper opening OP2-U. Through this, the second upper electrode UE2 may be electrically connected to the conductive barrier rib CPW and receive a bias voltage through the conductive barrier rib CPW.

In the disclosure, the third upper electrode UE3 may come in contact with the inner side surface of the first conductive layer CDL1 defining the first region OP3-U1 of the third upper opening OP3-U. Through this, the third upper electrode UE3 may be electrically connected to the conductive barrier rib CPW and receive a bias voltage through the conductive barrier rib CPW.

According to the disclosure, since the first to third upper electrodes UE1, UE2, and UE3 may not be provided in the form of a common layer overlapping all of the first to third light-emitting patterns EP1, EP2, and EP3, a lateral leakage current occurring through the common layer may not occur. As the upper electrodes UE1, UE2, and UE3 are electrically connected to the conductive barrier rib CPW having a relatively large thickness, driving resistance may be reduced so that the first to third light-emitting elements ED1, ED2, and ED3 with increased light-emitting efficiency and improved lifetime may be provided.

Capping patterns CP1, CP2, and CP3 may include a first capping pattern CP1 disposed on the first upper electrode UE1 inside the first upper opening OP1-U, a second capping pattern CP2 disposed on the second upper electrode UE2 inside the second upper opening OP2-U, and a third capping pattern CP3 disposed on the third upper electrode UE3 inside the third upper opening OP3-U. The first to third capping patterns CP1, CP2, and CP3 may be patterned by the tip portion defined in the conductive barrier rib CPW. According to another embodiment, the first to third capping patterns CP1, CP2, and CP3 may be omitted.

FIGS. 5A and 5B illustrate that the first capping pattern CP1 does not come in contact with the inner side surface of the first conductive layer CDL1 defining the first upper opening OP1-U, but the disclosure is not limited thereto. For example, the first capping pattern CP1 may be formed to come in contact with the inner side surface of the first conductive layer CDL1 defining the first upper opening OP1-U.

The thin film encapsulation layer TFE may be disposed on the display element layer DP-OLED. The thin film encapsulation layer TFE may include a first inorganic encapsulation pattern LIL1, a second inorganic encapsulation pattern LIL2, a third inorganic encapsulation pattern LIL3, an organic encapsulation film OL, and an upper inorganic encapsulation film UTL.

The first inorganic encapsulation pattern LIL1 may be formed on the conductive barrier rib CPW and the first upper electrode UE1 and disposed inside the first upper opening OP1-U. Specifically, the first inorganic encapsulation pattern LIL1 may cover the first upper electrode UE1 and the first capping pattern CP1. The first inorganic encapsulation pattern LIL1 may come in contact with the inner side surface of the first conductive layer CDL1 defining the first upper opening OP1-U.

The first inorganic encapsulation pattern LIL1 may include a first central portion OPA1 on the upper surface thereof and a first peripheral portion SPA1 surrounding the first central portion OPA1. The first central portion OPA1 may correspond to the first light-emitting region PXA-R. The first central portion OPA1 may be disposed adjacent to the center of the first light-emitting region PXA-R. Although a corner of the first central portion OPA1 is illustrated as being bent at a predetermined or selected angle in the drawing, the corner of the first central portion OPA1 is not limited thereto and may have a curvature.

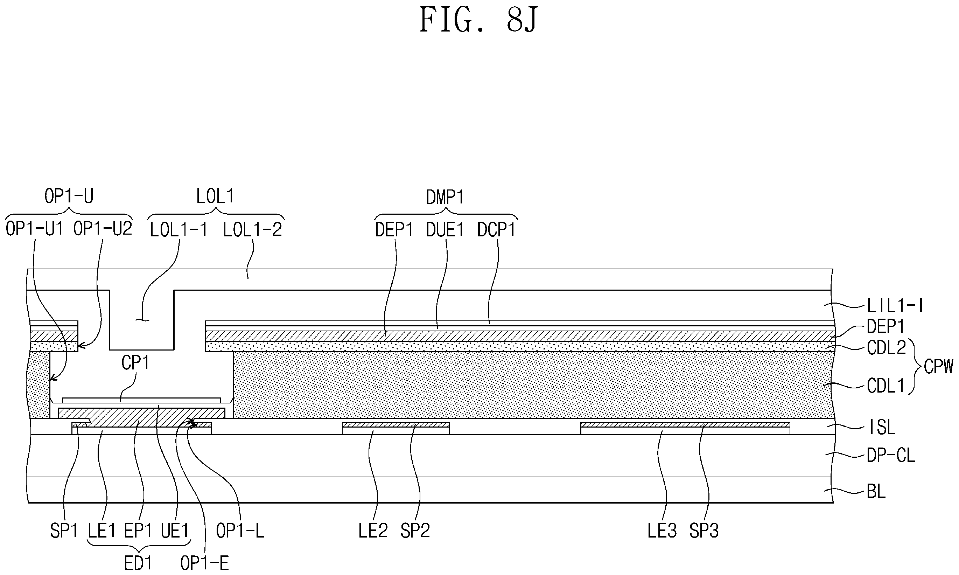

The first central portion OPA1 may be recessed toward the base layer BL. This may be because, in a manufacturing process, an etch rate of a first organic layer LOL1 (see FIG. 8J) may be higher than an etch rate of a first inorganic encapsulation layer LIL1-1 (see FIG. 8J). A detailed description of this will be provided later.

Since the first central portion OPA1 is recessed toward the base layer BL, the first peripheral portion SPA1 may be positioned closer to the second conductive layer CDL2 than the first central portion OPA1. Accordingly, a portion of the first upper electrode UE1 in contact with the first conductive layer CDL1 may be prevented from being exposed to the outside.

A minimum thickness TO1 of the first central portion OPA1 may be greater than a minimum thickness TO2 of a second central portion OPA2 to be described later.

A first step difference LS1 may be formed at a portion at which the first central portion OPA1 and the first peripheral portion SPA1 are connected to each other on the upper surface of the first inorganic encapsulation pattern LIL1. Although a corner of the first step difference LS1 is illustrated as being bent at a predetermined or selected angle, the corner of the first step difference LS1 is not limited thereto and may have a curvature.

The first central portion OPA1 may have a flat upper surface except for a region adjacent to the first step difference LS1. The first peripheral portion SPA1 may have a flat upper surface except for a region adjacent to the first step difference LS1.

The second inorganic encapsulation pattern LIL2 may be disposed on the conductive barrier rib CPW and the second upper electrode UE2 inside the second upper opening OP2-U. The second inorganic encapsulation pattern LIL2 may be disposed to be spaced apart from the first inorganic encapsulation pattern LIL1. Specifically, the second inorganic encapsulation pattern LIL2 may cover the second upper electrode UE2 and the second capping pattern CP2. The second inorganic encapsulation pattern LIL2 may come in contact with the inner side surface of the first conductive layer CDL1 defining the second upper opening OP2-U.

The second inorganic encapsulation pattern LIL2 may include a second central portion OPA2 on the upper surface thereof and a second peripheral portion SPA2 surrounding the second central portion OPA2. The second central portion OPA2 may correspond to the second light-emitting region PXA-G. The second central portion OPA2 may be disposed adjacent to the center of the second light-emitting region PXA-G. In the drawing, a corner of the second central portion OPA2 is illustrated as being bent at a predetermined or selected angle, but the corner of the second central portion OPA2 is not limited thereto and may have a curvature.

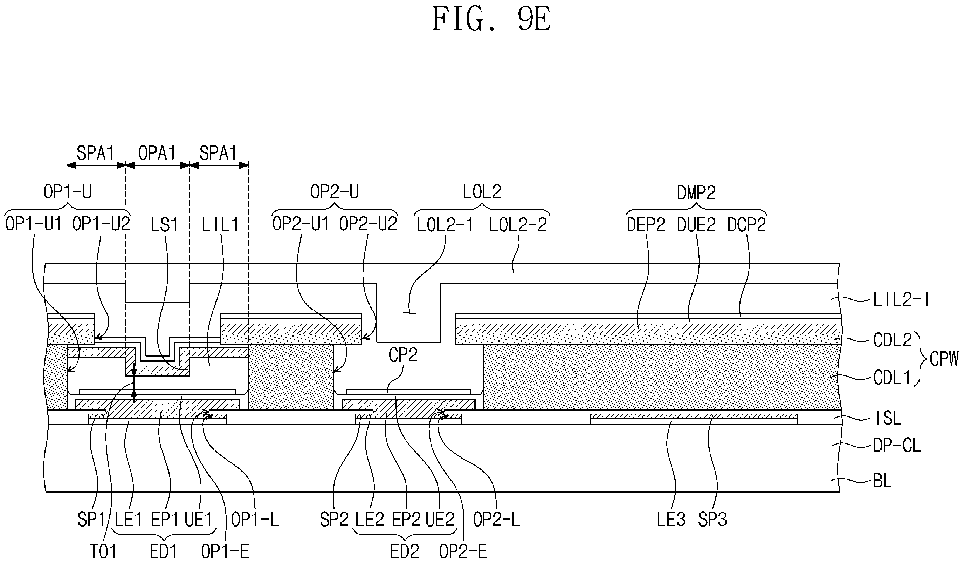

The second central portion OPA2 may be recessed toward the base layer BL. This may be because, in a manufacturing process, an etch rate of the second organic layer LOL2 (see FIG. 9E) may be higher than an etch rate of the second inorganic encapsulation layer LIL2-I (see FIG. 9E). A detailed description of this will be provided later.

Since the second central portion OPA2 is recessed toward the base layer BL, the second peripheral portion SPA2 may be positioned closer to the second conductive layer CDL2 than the second central portion OPA2. Accordingly, a portion of the second upper electrode UE2 in contact with the first conductive layer CDL1 may be prevented from being exposed to the outside.

A second step difference LS2 may be formed at a portion at which the second central portion OPA2 and the second peripheral portion SPA2 are connected to each other on the upper surface of the second inorganic encapsulation pattern LIL2. Although a corner of the second step difference LS2 is illustrated as being bent at a predetermined or selected angle, the corner of the second step difference LS2 may have a curvature.

The second central portion OPA2 may have a flat upper surface except for a region adjacent to the second step difference LS2. The second peripheral portion SPA2 may have a flat upper surface except for a region adjacent to the second step difference LS2.

The third inorganic encapsulation pattern LIL3 may be disposed on the conductive barrier rib CPW and the third upper electrode UE3 inside the third upper opening OP3-U. Specifically, the third inorganic encapsulation pattern LIL3 may cover the third upper electrode UE3 and the third capping pattern CP3. The third inorganic encapsulation pattern LIL3 may come in contact with the inner side surface of the first conductive layer CDL1 defining the third upper opening OP3-U.

The third inorganic encapsulation pattern LIL3 may include a third central portion OPA3 on the upper surface thereof and a third peripheral portion SPA3 surrounding the third central portion OPA3. The third central portion OPA3 may correspond to the third light-emitting region PXA-B. The third central portion OPA3 may be disposed adjacent to the center of the third light-emitting region PXA-B. In the drawing, a corner of the third central portion OPA3 is illustrated as being bent at a predetermined or selected angle, but the corner of the third central portion OPA3 is not limited thereto and may have a curvature.

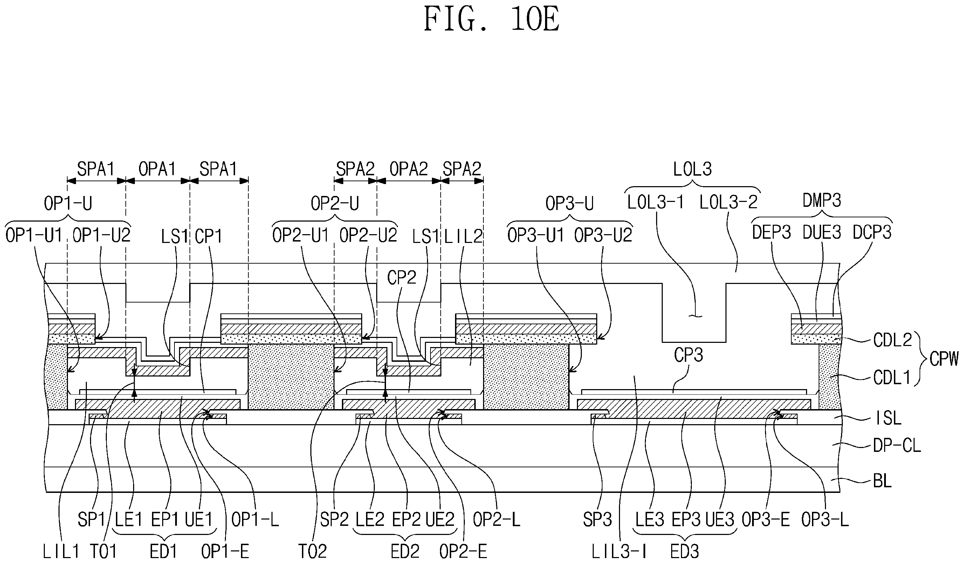

The third central portion OPA3 may be recessed toward the base layer BL. This may be because, in a manufacturing process, an etch rate of a third organic layer LOL3 (see FIG. 10E) may be higher than an etch rate of a third inorganic encapsulation layer LIL3-I (see FIG. 10E). A detailed description of this will be provided later.

Since the third central portion OPA3 is recessed toward the base layer BL, the third peripheral portion SPA3 may be positioned closer to the second conductive layer CDL2 than the third central portion OPA3. Accordingly, a portion of the third upper electrode UE3 in contact with the first conductive layer CDL1 may be prevented from being exposed to the outside.

A minimum thickness TO3 of the third central portion OPA3, the minimum thickness TO1 of the first central portion OPA1, and the minimum thickness TO2 of the second central portion OPA2 may have different values. This is because the configurations of stacked structures to be etched may be different from each other in the case going through a same etching process in a manufacturing process. A detailed description of this will be provided later when the manufacturing method is described.

A third step difference LS3 may be formed at a portion at which the third central portion OPA3 and the third peripheral portion SPA3 of the upper surface of the third inorganic encapsulation pattern LIL3 are connected to each other. Although a corner of the third step difference LS3 is illustrated as being bent at a predetermined or selected angle, the corner of the third step difference LS3 is not limited thereto and may have a curvature.

The third central portion OPA3 may have a flat upper surface except for a region adjacent to the third step difference LS3. The third peripheral portion SPA3 may have a flat upper surface except for a region adjacent to the third step difference LS3.

The first to third inorganic encapsulation patterns LIL1, LIL2, and LIL3 and the upper inorganic encapsulation film UIL may protect the display element layer DP-OLED from moisture/oxygen, and the organic encapsulation film OL may protect the display element layer DP-OLED from foreign substances such as dust particles.

The organic encapsulation film OL may be disposed on the first inorganic encapsulation pattern LIL1, the second inorganic encapsulation pattern LIL2, and the third inorganic encapsulation pattern LIL3. The organic encapsulation film OL may have a flat upper surface despite the upper surface of each of the first to third inorganic encapsulation patterns LIL1, LIL2, and LIL3 on which a step difference is defined.

The organic encapsulation film OL containing an organic material may protect the first to third light-emitting elements ED1, ED2, and ED3 from external foreign substances such as dust. The organic encapsulation film OL may include an acryl-based organic layer. However, the material of the organic encapsulation film OL is not limited thereto and may contain various materials.

The upper inorganic encapsulation film UIL may be disposed on the organic encapsulation film OL and protect the first to third light-emitting elements ED1, ED2, and ED3 from moisture and oxygen. The upper inorganic encapsulation film UIL may contain an inorganic material. For example, the upper inorganic encapsulation film UIL may contain a silicon nitride layer, a silicon oxynitride layer, a silicon oxide layer, a titanium oxide layer, an aluminum oxide layer, or the like. However, the material of the upper inorganic encapsulation film UIL is not limited thereto and may include various materials.

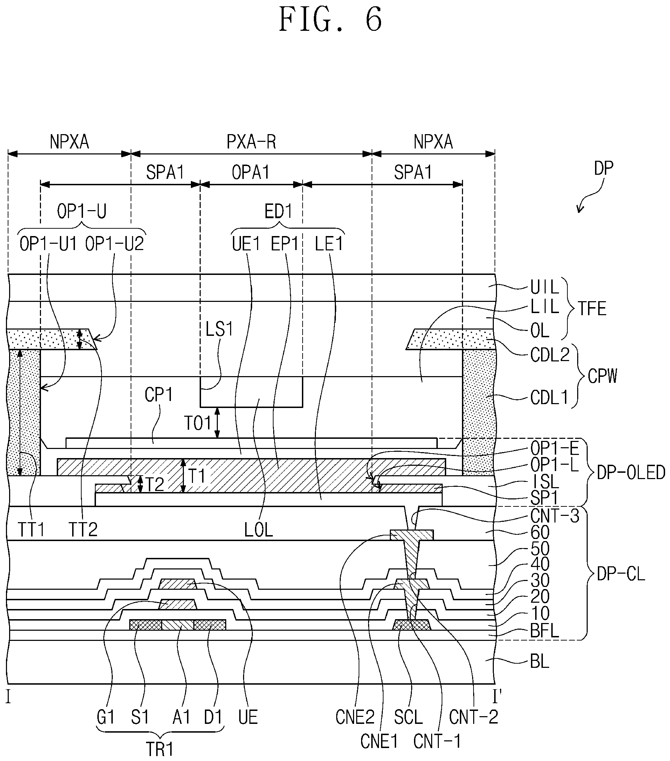

FIG. 6 is a schematic cross-sectional view of the display panel DP according to an embodiment, which is taken along line I-I' of FIG. 4. Since the display panel DP of FIG. 6 may be the same as the display panel DP of FIG. 5A at least except for an organic pattern LOL, a description of the same configuration will be omitted. Hereafter, only the organic pattern LOL overlapping the first light-emitting region PXA-R is described, but the same organic pattern LOL may also be formed in the second light-emitting region PXA-G and the third light-emitting region PXA-B.

The organic pattern LOL may be disposed on the first central portion OPA1 of the first inorganic encapsulation pattern LIL1. The organic pattern LOL may cover the first step difference LS1 of the first central portion OPA1. The organic pattern LOL may fill the recessed portion of the first central portion OPA1. An upper surface of the organic pattern LOL may have the same height as an upper surface of the first peripheral portion SPA1.

The organic pattern LOL may overlap the first central portion OPA1 and may not overlap the first peripheral portion SPA1. The organic pattern LOL may be disposed between the first inorganic encapsulation pattern LIL1 and the organic encapsulation film OL. For example, the organic encapsulation film OL may be disposed on the first inorganic encapsulation pattern LIL1 and the organic pattern LOL. The organic pattern LOL may contain a material different from that of the organic encapsulation film OL.

For example, the organic pattern LOL may contain an organic material that is cured at a relatively low temperature (about 80 °C to about 100 °C) to prevent damage to the first light-emitting element ED1. For example, the organic pattern LOL may contain photoresist. The organic encapsulation film OL may contain an organic material that is cured at a higher temperature (about 230 °C to about 260 °C) than the organic pattern LOL.

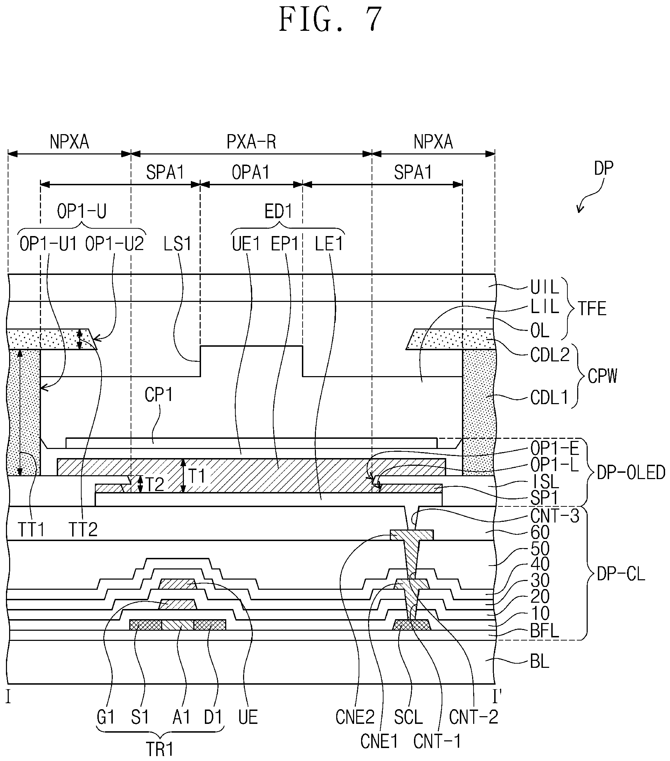

FIG. 7 is a schematic cross-sectional view of the display panel DP according to an embodiment, which is taken along line I-I' of FIG. 4. As the display panel DP of FIG. 7 may be the same as the display panel DP of FIG. 5A at least except for the shape of the first central portion OPA1, a description of the same configuration will be omitted.

Referring to FIG. 7, the first central portion OPA1 may protrude toward the outside. Here, the word "outside" may refer to a side through which a user visually recognizes light emitted from the first light-emitting element ED1. This may be because, in a manufacturing process, an etch rate of the first organic layer LOL1 (see FIG. 8J) is lower than an etch rate of the first inorganic encapsulation layer LIL1-I (see FIG. 8J). A detailed description of this will be provided later.

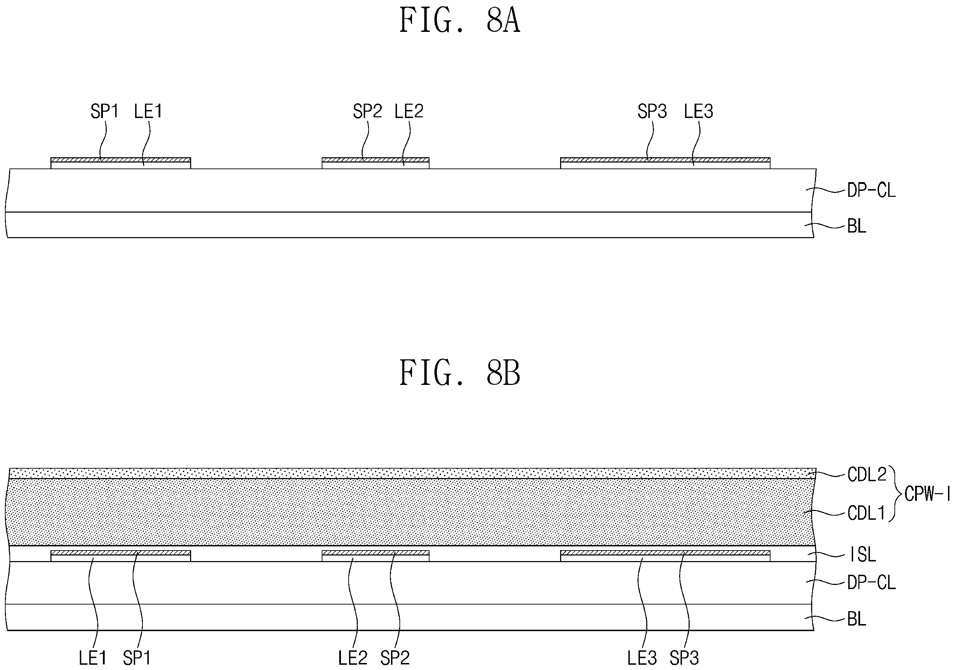

FIGS. 8A to 8L are schematic cross-sectional views illustrating some steps of a method of manufacturing the display device DD (see FIG. 1B) according to an embodiment. Hereinafter, the method of manufacturing the display device DD (see FIG. 1B) will be described step by step.

Referring to FIG. 8A, the method of manufacturing the display device DD may include forming a circuit element layer DP-CL, first to third lower electrodes LE1, LE2, and LE3, and first to third sacrificial patterns SP1, SP2 and SP3. The circuit element layer DP-CL may be formed through a typical circuit element manufacturing process in which an insulating layer, a semiconductor layer, and a conductive layer are formed by a method such as coating or deposition, and then the insulating layer, the semiconductor layer, and the conductive layer are selectively patterned through photolithography and etching processes to form a semiconductor pattern, a conductive pattern, a signal line, and the like.

The first to third lower electrodes LE1, LE2, and LE3 may be formed on the sixth insulating layer 60 (see FIG. 5A) of the circuit element layer DP-CL, and the first to third sacrificial patterns SP1, SP2, and SP3 may be respectively formed on the first to third lower electrodes LE1, LE2, and LE3. The first to third lower electrodes LE1, LE2, and LE3 and the first to third sacrificial patterns SP1, SP2, and SP3 may be formed by a same patterning process.

Referring to FIG. 8B, an insulating film ISL may be formed on the sixth insulating layer 60 (see FIG. 5A) of the circuit element layer DP-CL. The insulating film ISL may cover the first to third lower electrodes LE1, LE2, and LE3 and the first to third sacrificial patterns SP1, SP2, and SP3. A conductive barrier rib layer CPW-I may be formed on the insulating film ISL. The conductive barrier rib layer CPW-I may include a first conductive layer CDL1 and a second conductive layer CDL2. The first conductive layer CDL1 may have a first conductivity and a first thickness TT1 (refer to FIG. 5A). The second conductive layer CDL2 may have a second conductivity lower than the first conductivity and a second thickness TT2 (see FIG. 5A) smaller than the first thickness TT1 (see FIG. 5A).

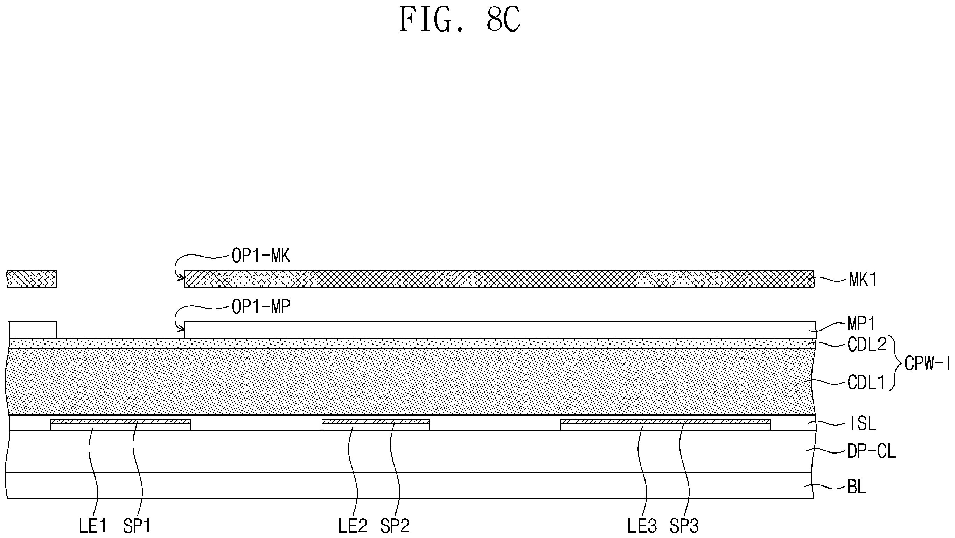

Referring to FIG. 8C, a first mask pattern MP1 may be formed on the conductive barrier rib layer CPW-I. The first mask pattern MP1 may be formed through exposure and development processes by using a first photo mask MK1 having a first mask opening OP1-MK. A first photo opening OP1-MP corresponding to the first mask opening OP1-MK may be formed in the first mask pattern MP1. The first mask opening OP1-MK and the first photo opening OP1-MP may overlap the first lower electrode LE1.

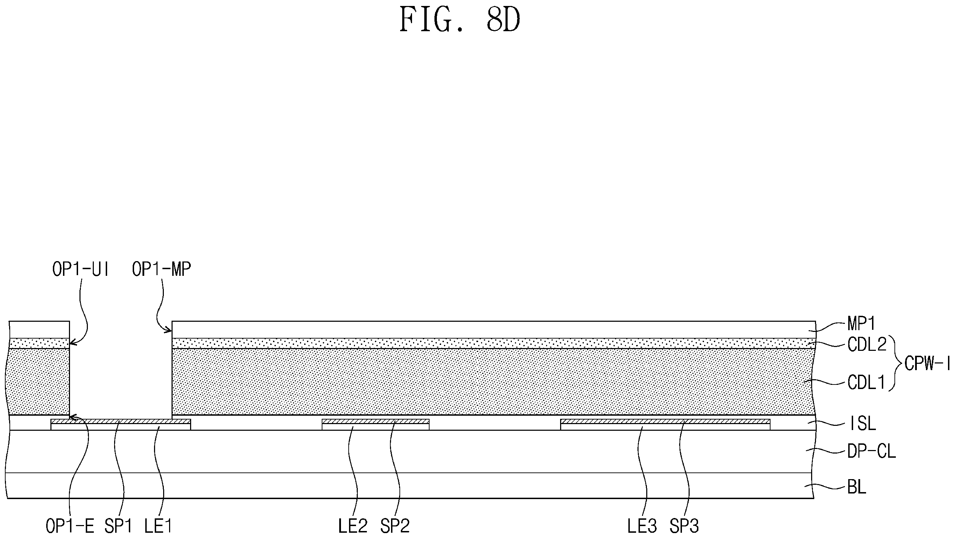

Referring to FIG. 8D, a preliminary first upper opening OP1-UI corresponding to the light-emitting region PXA-R (see FIG. 5B) may be formed by dry-etching the first conductive layer CDL1 and the second conductive layer CDL2 with the use of the first mask pattern MP1 as a mask. A first light-emitting opening OP1-E exposing a portion of the upper surface of the first lower electrode LE1 may be formed by dry-etching the insulating film ISL.

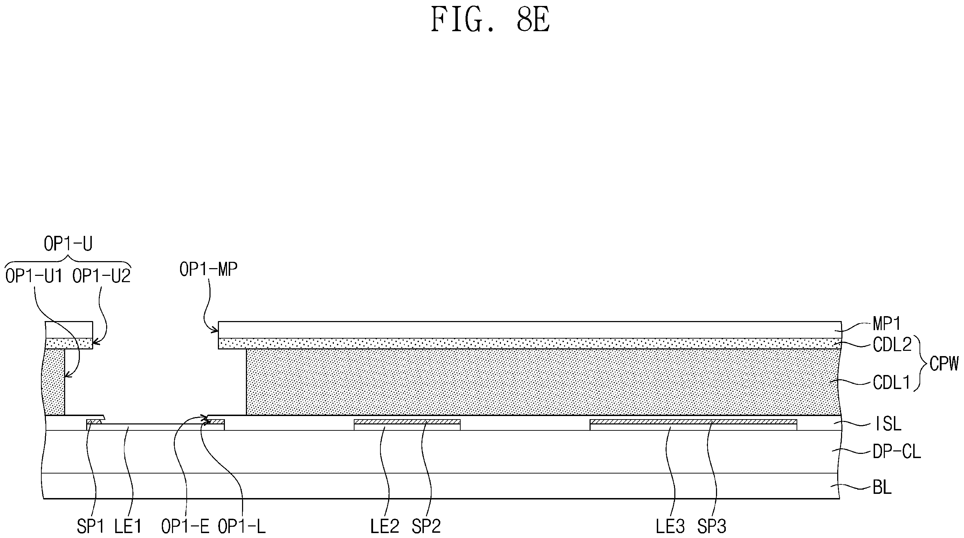

Referring to FIG. 8E, the first conductive layer CDL1 and the second conductive layer CDL2 may be wet-etched by using the first mask pattern MP1 as a mask. Accordingly, the conductive barrier rib CPW having a first upper opening OP1-U formed therein may be formed. For example, after being wet-etched, the first conductive layer CDL1 and the second conductive layer CDL2 may form the conductive barrier rib CPW.

In a wet etching process of the first conductive layer CDL1 and the second conductive layer CDL2, as the etch rate of the first conductive layer CDL1 with respect to an etching solution may be higher than the etch rate of the second conductive layer CDL2, the first conductive layer CDL1 may be mainly etched. Accordingly, after the wet etching is completed, on a cross section, the inner side surface of the second conductive layer CDL2 defining the second region OP1-U2 of the first upper opening OP1-U may be closer to the center of the first lower electrode LE1 than the inner side surface of the first conductive layer CDL1 defining the first region OP1-U1 of the first upper opening OP1-U. A tip portion may be formed in the second conductive layer CDL2 of the conductive barrier rib CPW.

The insulating film ISL and the first sacrificial pattern SP1 may be wet-etched by using the first mask pattern MP1 as a mask. A first lower opening OP1-L exposing a portion of the upper surface of the first lower electrode LE1 may be formed in the first sacrificial pattern SP1. The first lower opening OP1-L may be formed to have an area larger than that of the first light-emitting opening OP1-E. A tip portion may be formed in the insulating film ISL. In a wet etching process of the insulating film ISL and the first sacrificial pattern SP1, since the etch rate of the first sacrificial pattern SP1 with respect to an etching solution may be higher than the etch rate of the insulating film ISL, the first sacrificial pattern SP1 may be mainly etched.

The etch rate of the first lower electrode LE1 with respect to an etching solution may be low (e.g., very low) compared to the etch rate of the first sacrificial pattern SP1. Therefore, it may be possible to prevent the first lower electrode LE1 from being etched together in an etching process of the first sacrificial pattern SP1. For example, by disposing the first sacrificial pattern SP1 containing a material having a high selectivity compared to the first lower electrode LE1 between the first lower electrode LE1 and the insulating film ISL, it may be possible to prevent the first lower electrode LE1 from being etched together and damaged.

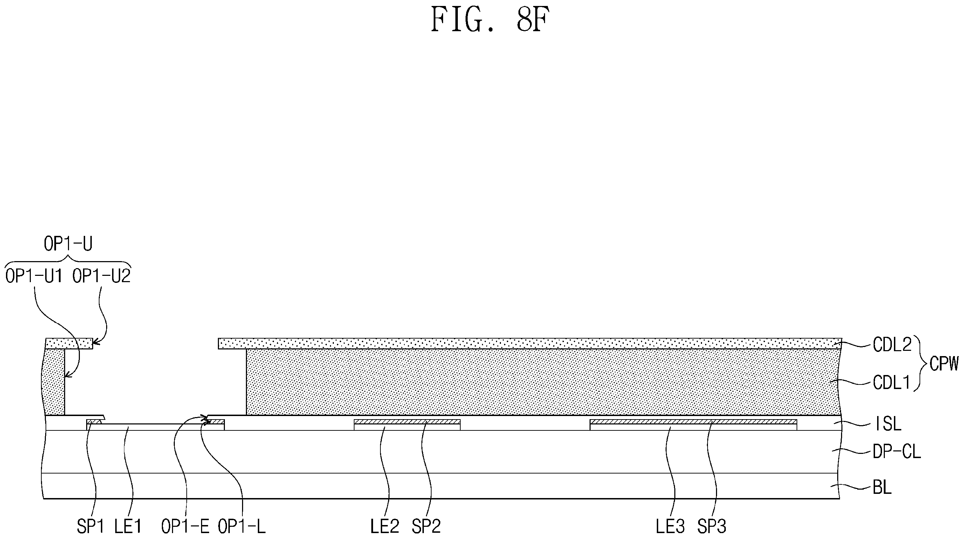

Referring to FIG. 8F, the first mask pattern MP1 (see FIG. 8E) may be removed. The first mask pattern MP1 (see FIG. 8E) may be removed by using a liquid resist stripper. The first mask pattern MP1 (see FIG. 8E) may be removed by plasma containing oxygen.

Through a series of processes illustrated in FIGS. 8A to 8F, a preliminary display panel including the conductive barrier rib CPW having the first upper opening OP1-U defined therein, the base layer BL, the circuit element layer DP-CL, the first lower electrode LE1, the first sacrificial pattern SP1, and the insulating film ISL may be provided.

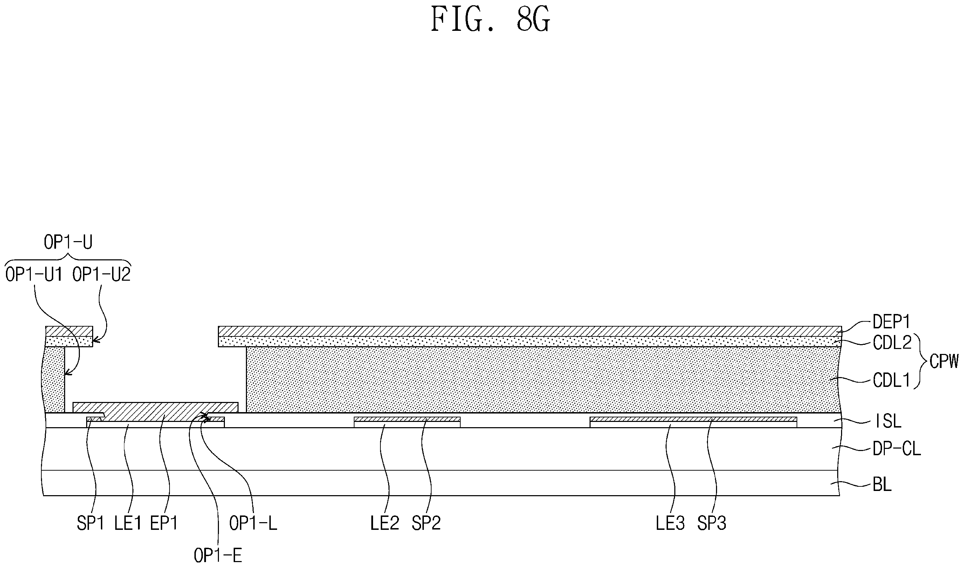

Referring to FIG. 8G, a first light-emitting pattern EP1 disposed on the first lower electrode LE1 inside the first upper opening OP1-U may be formed. A dummy first light-emitting pattern DEP1 disposed on the upper surface of the conductive barrier rib CPW may be formed. The first light-emitting pattern EP1 and the dummy first light-emitting pattern DEP1 may be formed through a thermal evaporation process.

The first light-emitting pattern EP1 and the dummy first light-emitting pattern DEP1 may contain a same material and have a same structure. As the first light-emitting pattern EP1 and the dummy first light-emitting pattern DEP1 are deposited separately from each other by the tip portion defined in the conductive barrier rib CPW, they may be formed to be spaced apart from each other. The first light-emitting pattern EP1 may be formed on the first lower electrode LE1 inside the first lower opening OP1-L, the first light-emitting opening OP1-E, and the first upper opening OP1-U.

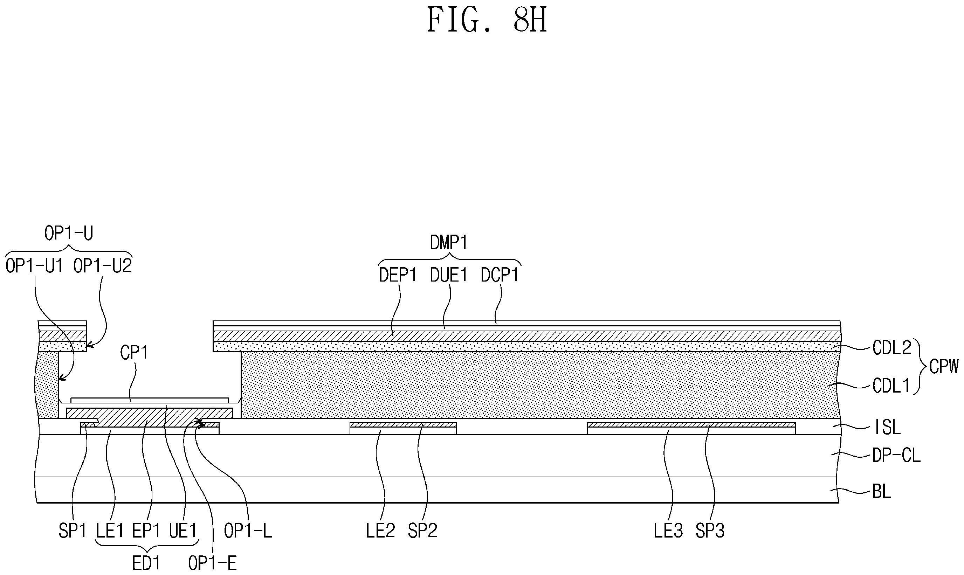

Referring to FIG. 8H, a first upper electrode UE1 may be formed, which is disposed on the first light-emitting pattern EP1 inside the first upper opening OP1-U1 and comes in contact with the inner side surface of the conductive barrier rib CPW defining the first upper opening OP1-U. At the same time, a dummy first upper electrode DUE1 disposed on the dummy first light-emitting pattern DEP1 may be formed. The first upper electrode UE1 and the dummy first upper electrode DUE1 may contain a same material and have a same structure. The first upper electrode UE1 may be formed through a sputtering process.

The first upper electrode UE1 may be provided at a higher incidence angle than the first light-emitting pattern EP1, and the first upper electrode UE1 may be formed so as to come in contact with the inner side surface of the first conductive layer CDL1 defining the first upper opening OP1-U. The first upper electrode UE1 may be continuously formed inside the first upper opening OP1-U without being separated. Accordingly, the first upper electrode UE1 may not be electrically disconnected to the conductive barrier rib CPW, and a defective first light-emitting element ED1 may not be provided.

The first upper electrode UE1 and the dummy first upper electrode DUE1 may be formed to be spaced apart from each other as they are deposited separately from each other by the tip portion defined in the conductive barrier rib CPW.

A first capping pattern CP1 may be formed on the first upper electrode UE1 inside the first upper opening OP1-U, and a dummy first capping layer DCP1 may be formed on the dummy first upper electrode DUE1. The first capping pattern CP1 may cover a portion of the upper surface of the first upper electrode UE1. A first dummy pattern DMP1 may include the dummy first light-emitting pattern DEP1, the dummy first upper electrode DUE1, and the dummy first capping layer DCP1.

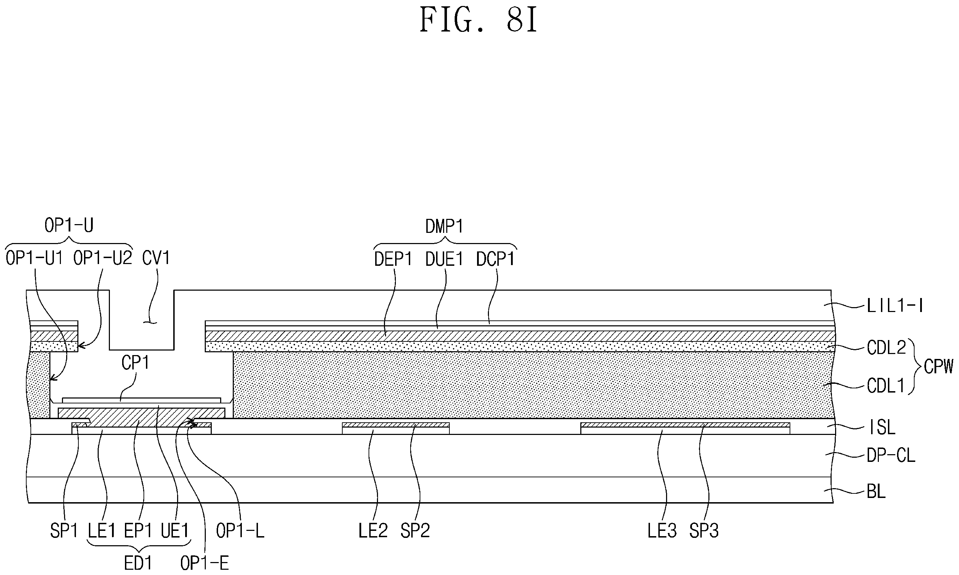

Referring to FIG. 8I, a first inorganic encapsulation layer LIL1-I overlapping the light-emitting region PXA-R (see FIG. 5B) and the non-light-emitting region NPXA (see FIG. 5B) may be formed on the first upper electrode UE1, the first capping pattern CP1, and the first dummy pattern DMP1. A first cavity CV1 overlapping the first light-emitting region PXA-R (see FIG. 5B) may be defined in the first inorganic encapsulation layer LIL1-I. The first cavity CV1 may have a shape corresponding to the first upper opening OP1-U. The first cavity CV1 may be a concave portion recessed toward the base layer BL. The first cavity CV1 may correspond to the first central portion OPA1 (see FIG. 5B). The first inorganic encapsulation layer LIL-1-I may be formed through a chemical vapor deposition (CVD) process.

Referring to FIG. 8J, a first organic layer LOL1 may be formed on the first inorganic encapsulation layer LILI -I. The first organic layer LOL1 may include a first filling portion LOL1-1 disposed in the first cavity CV1 and a first flat portion LOL1-2 having a flat upper surface. The first organic layer LOL1 may cover the upper surface of the first inorganic encapsulation layer LIL1-I having a step difference and form a flat upper surface.

Accordingly, the first light-emitting element ED1 may not be damaged despite ashing and dry etching processes to be described later. For example, in the case that the first organic layer LOL1 is not filled, the distance between the first light-emitting element ED1 and the lower surface of the first inorganic encapsulation layer LII,1-I defining the first cavity CV1 may be too small.

In the case that the first inorganic encapsulation layer LIL1-I is etched to the extent of removing the first dummy pattern DMP1 in the ashing and dry etching processes, the first light-emitting element ED1 as well as the first inorganic encapsulation layer LIL1-I may be also etched and damaged in a portion corresponding to the first cavity CV1. Therefore, prior to the ashing and dry etching processes, the first organic layer LOL1 may fill the first cavity CV1 and flatten the upper surface, thereby preventing damage to the first light-emitting element ED1.

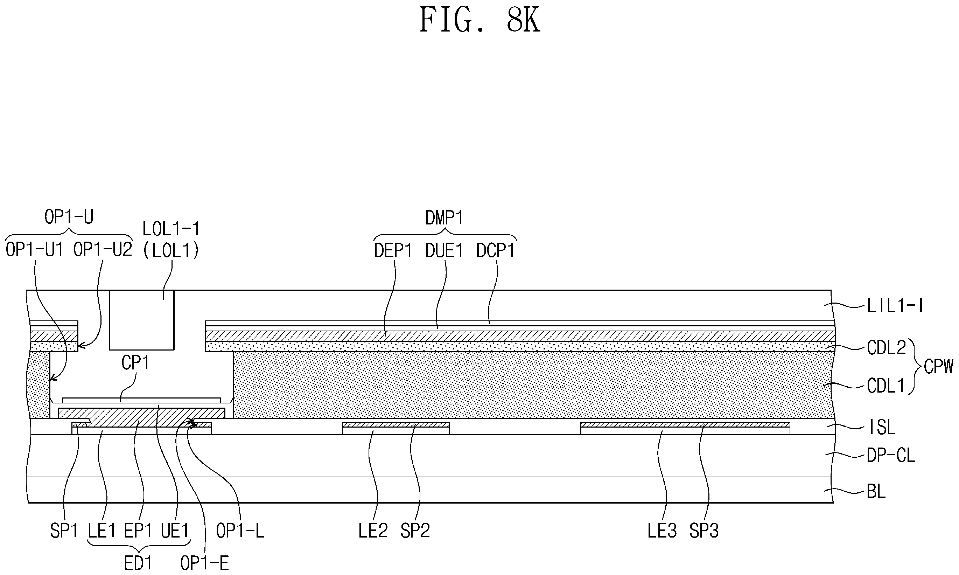

Referring to FIG. 8K, the first flat portion LOL1-2 of the first organic layer LOL1 may be removed. The first flat portion LOL1-2 may be removed by an ashing method. For example, only the first flat portion LOL1-2 containing an organic material may be effectively removed through an oxygen plasma ashing process.

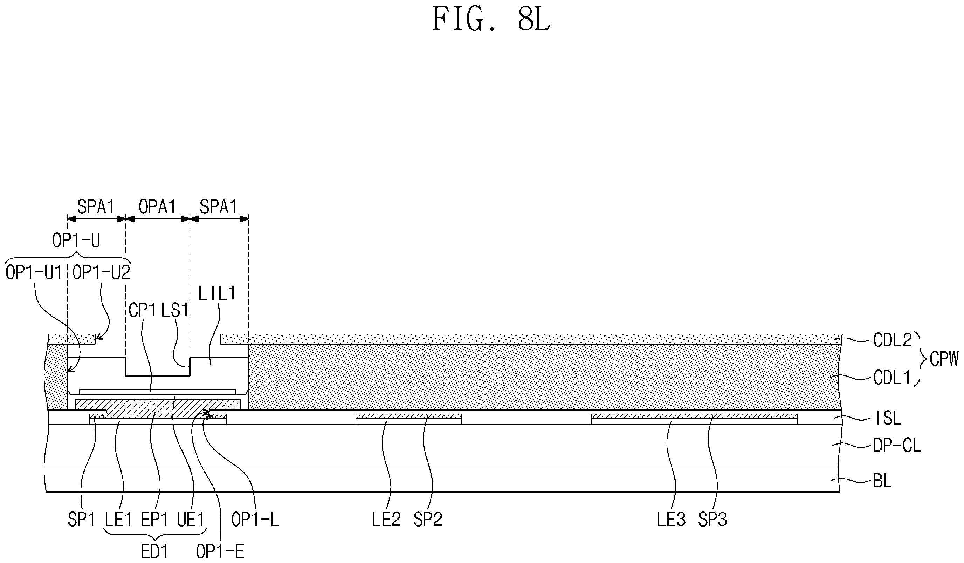

Referring to FIGS. 8K and 8L, by removing at least a portion of the first filling portion LOL1-1 and a portion of the first inorganic encapsulation layer LIL-1-I, the first inorganic encapsulation pattern LIL1 may be formed in the first upper opening OP1-U. The first dummy pattern DMP1 including the dummy first light-emitting pattern DEP1, the dummy first upper electrode DUE1, and the dummy first capping layer DCP1 may be removed. The forming of the first inorganic encapsulation pattern LIL1 and the removing of the first dummy pattern DMP1 may be performed through a same etching step. The forming of the first inorganic encapsulation pattern LIL1 and the removing of the first dummy pattern DMP1 may be performed by a dry etching method.

After the first filling portion LOL1-1 and the first inorganic encapsulation layer LIL1-I existing on the first dummy pattern DMP1 are etched, the first dummy pattern DMP1 may be etched. In this way, since the etching is performed after planarization of the upper surface by stacking the first organic layer LOL1 (see FIG. 8J), the first light-emitting element ED1 may be patterned without using a separate mask.

In a dry etching process, the etch rates of the first inorganic encapsulation layer LIL1-I and the first organic layer LOL1 may be different from each other. The etch rate of the first organic layer LOL1 according to an embodiment may be higher than that of the first inorganic encapsulation layer LIL1-I. Accordingly, the first inorganic encapsulation layer LIL1-I corresponding to a portion in which the first organic layer LOL1 remains in FIG. 8K may be formed to be the first central portion OPA1 of the first inorganic encapsulation pattern LIL1 of FIG. 8L. For example, the portion (corresponding to the first central portion OPA1) in which the first organic layer LOL1 remains is etched faster than a portion (corresponding to the first peripheral portion SPA1) in which the first organic layer LOL1 does not exist, and therefore, the first central portion OPA1 may have a shape recessed toward the base layer BL.

As a result of such formation, the height of the upper surface of the first peripheral portion SPA1 may be greater than the height of the upper surface of the first central portion OPA1. Accordingly, a contact portion between the first conductive layer CDL1 and the first upper electrode UE1 adjacent to the first peripheral portion SPA1 may be sufficiently covered and protected.

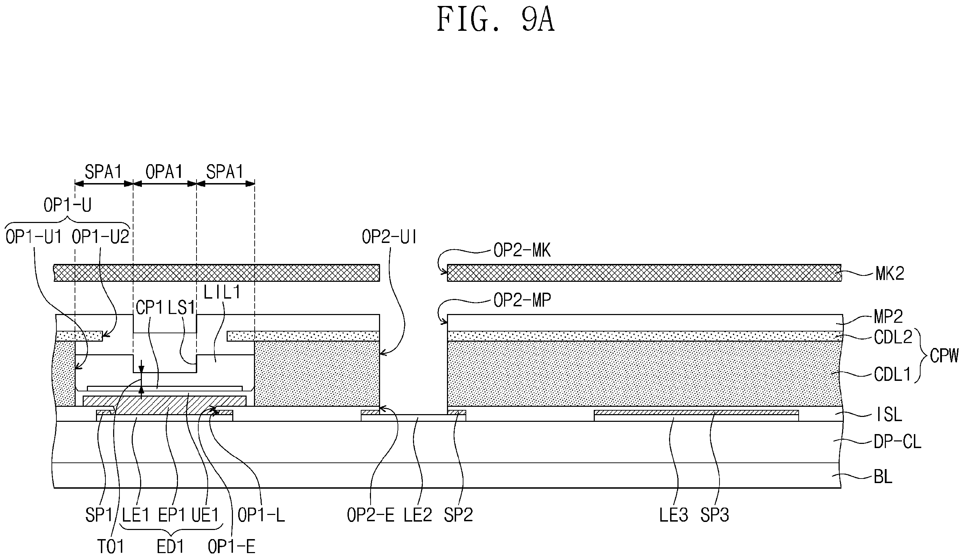

FIGS. 9A to 9G are schematic cross-sectional views illustrating some steps of the method of manufacturing the display device DD (see FIG. 1B) according to an embodiment. A series of processes illustrated in FIGS. 9A to 9G may be the same as the series of processes illustrated in FIGS. 8C to 8L, and therefore, a detailed description thereof will be omitted.

Referring to FIG. 9A, a second mask pattern MP2 may be formed on the conductive barrier rib CPW. The second mask pattern MP2 may be formed through exposure and development processes by using a second photo mask MK2 having a second mask opening OP2-MK. A second photo opening OP2-MP corresponding to the second mask opening OP2-MK may be formed in the second mask pattern MP2.

A preliminary second upper opening OP2-UI corresponding to the light-emitting region PXA-G (see FIG. 5B) may be formed by dry-etching the first conductive layer CDL1 and the second conductive layer CDL2 with the use of the second mask pattern MP2 as a mask. A second light-emitting opening OP2-E exposing a portion of the upper surface of the second lower electrode LE2 may be formed by dry-etching the insulating film ISL.

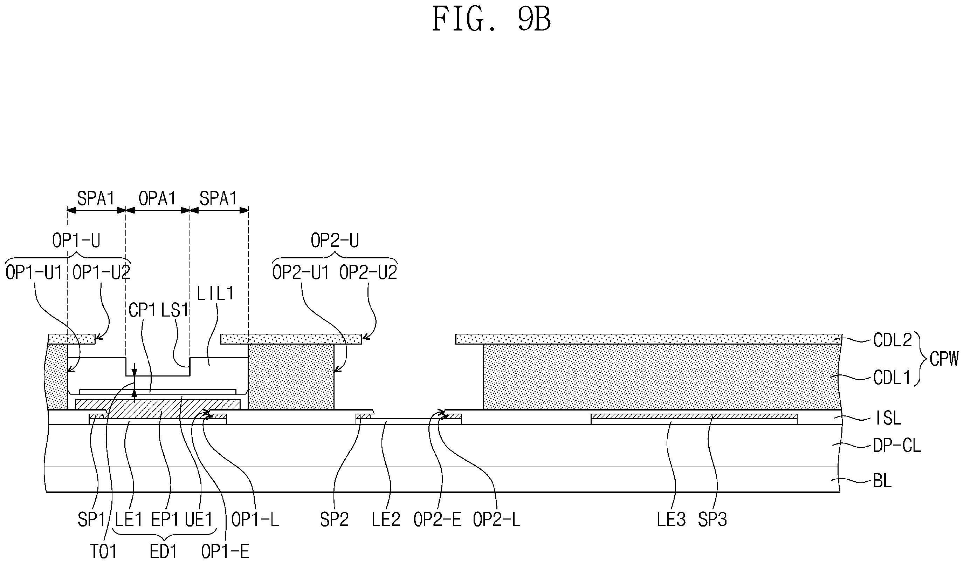

Referring to FIG. 9B, the first conductive layer CDL1 and the second conductive layer CDL2 may be wet-etched by using the second mask pattern MP2 (see FIG. 9A) as a mask. Accordingly, the conductive barrier rib CPW having a second upper opening OP2-U formed therein may be formed.

In the wet etching process of the first conductive layer CDL1 and the second conductive layer CDL2, as the etch rate of the first conductive layer CDL1 with respect to an etching solution may be higher than the etch rate of the second conductive layer CDL2, the first conductive layer CDL1 may be etched more than the second conductive layer CDL2.

By using the second mask pattern MP2 (see FIG. 9A) as a mask, the insulating film ISL and the second sacrificial pattern SP2 may be wet-etched. A second lower opening OP2-L exposing a portion of the upper surface of the second lower electrode LE2 may be formed in the second sacrificial pattern SP2. As the etch rate of the second sacrificial pattern SP2 with respect to an etching solution may be higher than the etch rate of the insulating film ISL, the second sacrificial pattern SP2 may be etched more than the insulating film ISL. Hereafter, the second mask pattern MP2 may be removed.

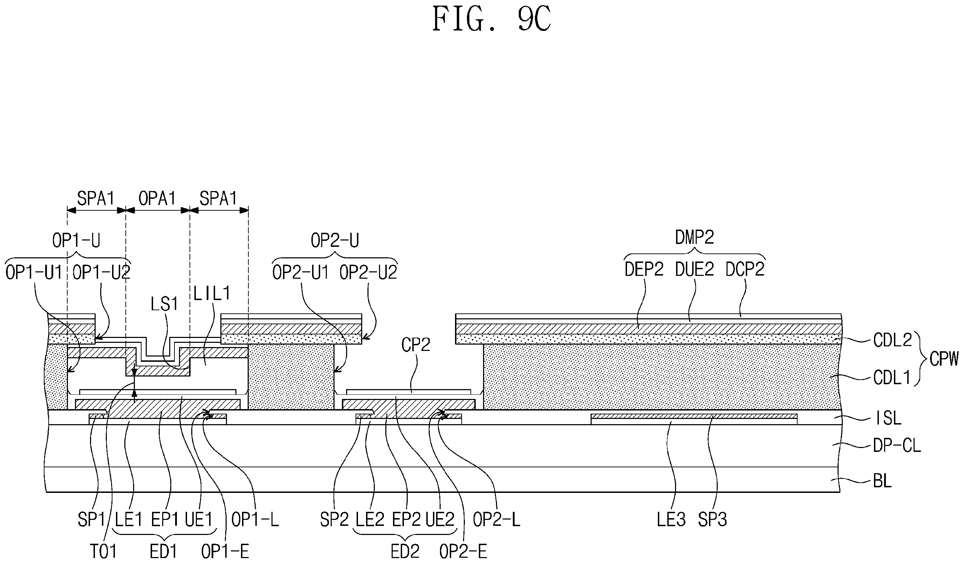

Referring to FIG. 9C, a second light-emitting element ED2 may be formed by sequentially stacking a second light-emitting pattern EP2, a second upper electrode UE2, and a second capping pattern CP2 in the second upper opening OP2-U. A second dummy pattern DMP2 may be formed by sequentially stacking a dummy second light-emitting pattern DEP2, a dummy second upper electrode DUE2, and a dummy second capping layer DCP2 on the upper surface of the second conductive layer CDL2. Since this may be performed in the same process as the process described in FIGS. 8G and 8H, a detailed description thereof will be omitted.

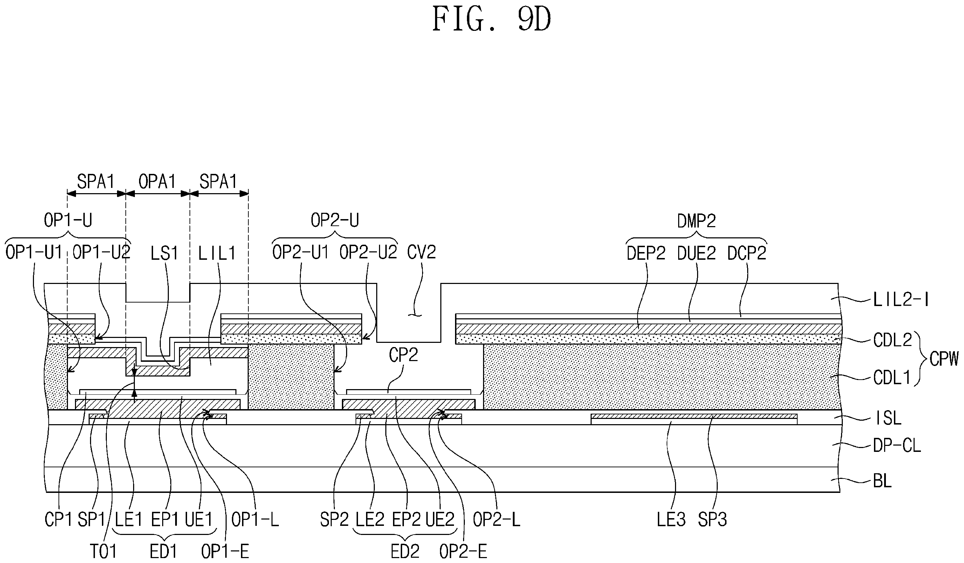

Referring to FIG. 9D, a second inorganic encapsulation layer LIL2-I overlapping the light-emitting regions PXA-R, PXA-G, and PXA-R (see FIG. 5B) and the non-light-emitting region NPXA (see FIG. 5B) may be formed on the second upper electrode UE2, the second capping pattern CP2, and the second dummy pattern DMP2 (see FIG. 5B). A second cavity CV2 overlapping the second light-emitting region PXA-G (see FIG. 5B) may be defined in the second inorganic encapsulation layer LIL2-I. The second cavity CV2 may have a shape corresponding to the second upper opening OP2-U. The second cavity CV2 may be a concave portion recessed toward the base layer BL. The second cavity CV2 may correspond to the second central portion OPA2 (see FIG. 5B). The second inorganic encapsulation layer LIL2-I may be formed through a chemical vapor deposition (CVD) process.

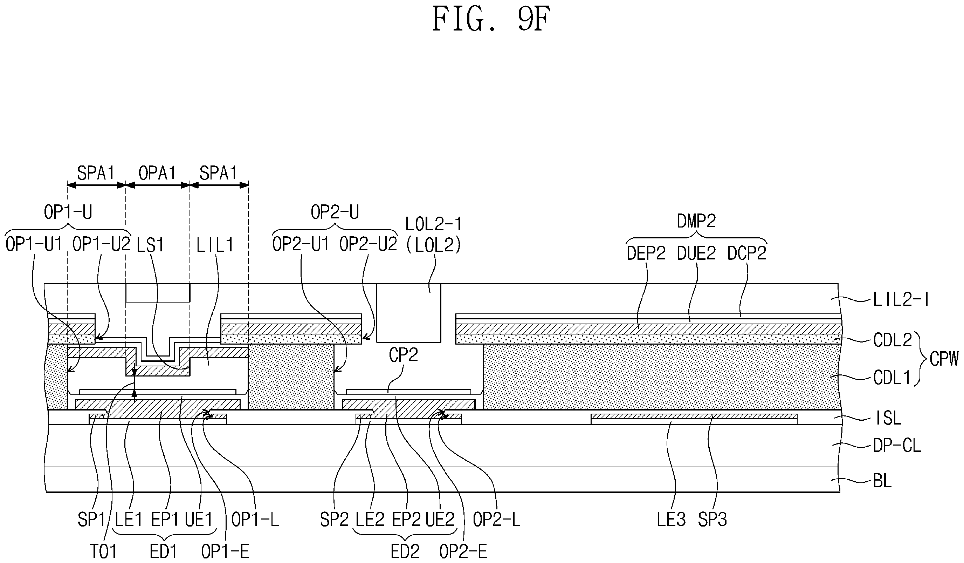

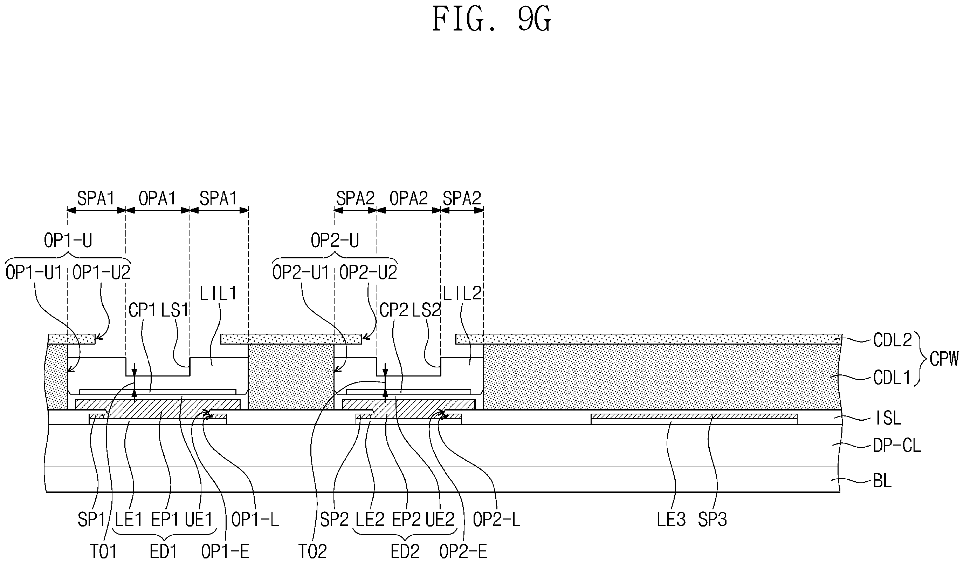

Referring to FIG. 9E, a second organic layer LOL2 may be formed on the second inorganic encapsulation layer LIL2-I. The second organic layer LOL2 may include a second filling portion LOL2-1 disposed in the second cavity CV2 and a second flat portion LOL2-2 having a flat upper surface. The second organic layer LOL2 may serve to protect the second light-emitting element ED2 from being damaged despite subsequent ashing and dry etching processes of FIGS. 9F and 9G.

Referring to FIGS. 9F and 9G, the second flat portion LOL2-2 (see FIG. 9E) of the second organic layer LOL2 may be removed. The second flat portion LOL2-2 may be removed by an ashing method. A second inorganic encapsulation pattern LIL2 may be formed in the second upper opening OP2-U by removing at least a portion of the second filling portion LOL2-1 and a portion of the second inorganic encapsulation layer LIL2-I. The second dummy pattern DMP2 including the dummy second light-emitting pattern DEP2, the dummy second upper electrode DUE2, and the dummy second capping layer DCP2 may be removed. The forming of the second inorganic encapsulation pattern LIL2 and the removing of the second dummy pattern DMP2 may be performed through a dry etching process.

At this time, in a region (hereinafter, a first etching region) corresponding to the first light-emitting region PXA-R of FIG. 9F (see FIG. 5B), the sequentially stacked dummy second light-emitting pattern DEP2, dummy second upper electrode DUE2, dummy second capping layer DCP2, second inorganic encapsulation layer LIL2-I, and second filling portion LOL2-1 may be etched. In a region (hereinafter, a second etching region) corresponding to the second light-emitting region PXA-G (see FIG. 5B) of FIG. 9F, the sequentially stacked second inorganic encapsulation layer LIL2-I and second filling portion LOL2-1 may be etched. The height of the second filling portion LOL2-1 positioned in the first etching region may be smaller than that of the second filling portion LOL2-1 positioned in the second etching region.

Accordingly, a stacked structure etched in the first etching region and a stacked structure etched in the second etching region may be different from each other. Since different materials have different etch rates, the etch rates in the first etching region and the second etching region may be different from each other during an etching process. Accordingly, as illustrated in FIG. 9G, although the etching may be performed through a same process, a thickness TO1 of the first inorganic encapsulation pattern LIL1 and a thickness TO2 of the second inorganic encapsulation pattern LIL2 may be different from each other.

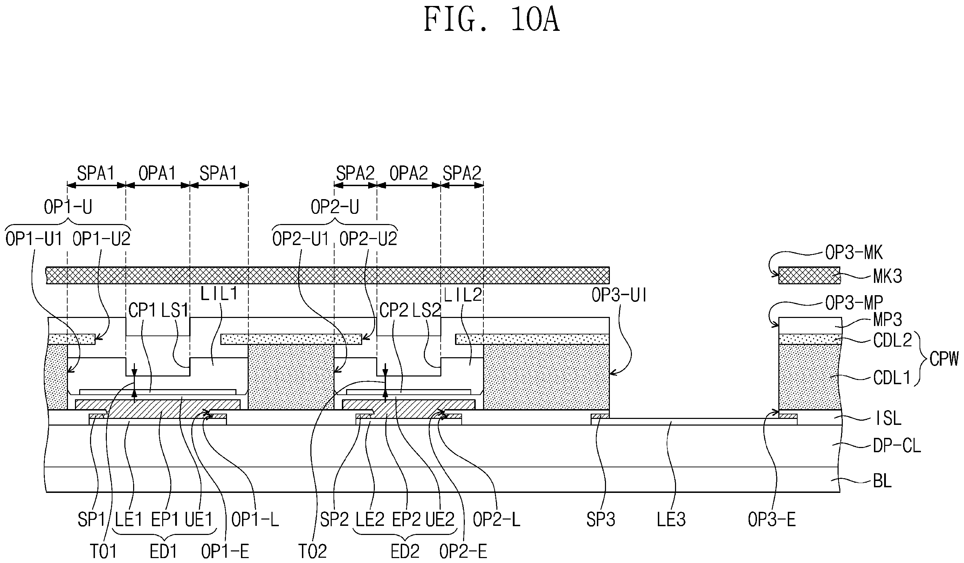

FIGS. 10A to 10G are schematic cross-sectional views illustrating some steps of the method of manufacturing the display device DD (see FIG. 1B) according to an embodiment. A series of processes illustrated in FIGS. 10A to 10G may be the same as the series of processes illustrated in FIGS. 8C to 8L, and therefore, a detailed description thereof will be omitted.

Referring to FIG. 10A, a third mask pattern MP3 may be formed on the conductive barrier rib CPW. The third mask pattern MP3 may be formed through exposure and development processes by using a third photo mask MK3 having a third mask opening OP3-MK. A third photo opening OP3-MP corresponding to the third mask opening OP3-MK may be formed in the third mask pattern MP3.

A preliminary third upper opening OP3-UI corresponding to the light-emitting region PXA-B (see FIG. 5B) may be formed by dry-etching the first conductive layer CDL1 and the second conductive layer CDL2 with the use of the third mask pattern MP3 as a mask. A third light-emitting opening OP3 -E exposing a portion of the upper surface of the third lower electrode LE3 may be formed by dry-etching the insulating film ISL.

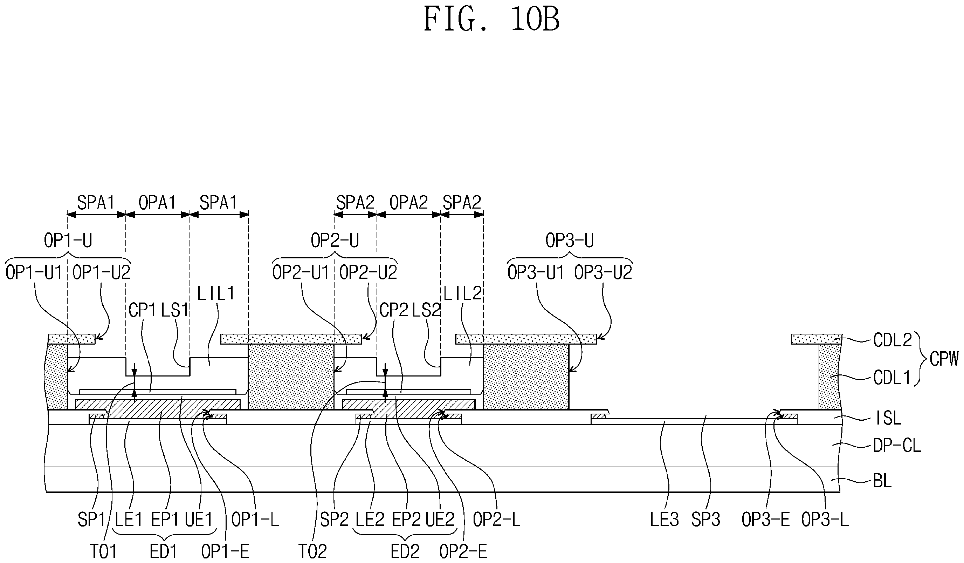

Referring to FIG. 10B, the first conductive layer CDL1 and the second conductive layer CDL2 may be wet-etched by using the third mask pattern MP3 (see FIG. 10A) as a mask. Accordingly, the conductive barrier rib CPW having a third upper opening OP3-U formed therein may be formed.

In the wet etching process of the first conductive layer CDL1 and the second conductive layer CDL2, as the etch rate of the first conductive layer CDL1 with respect to an etching solution may be higher than the etch rate of the second conductive layer CDL2, the first conductive layer CDL1 may be etched more than the second conductive layer CDL2.

The insulating film ISL and the third sacrificial pattern SP3 may be wet-etched by using the third mask pattern MP3 (see FIG. 10A) as a mask. A third lower opening OP3-L exposing a portion of the upper surface of the third lower electrode LE3 may be formed in the third sacrificial pattern SP3. Hereafter, the third mask pattern MP3 may be removed.

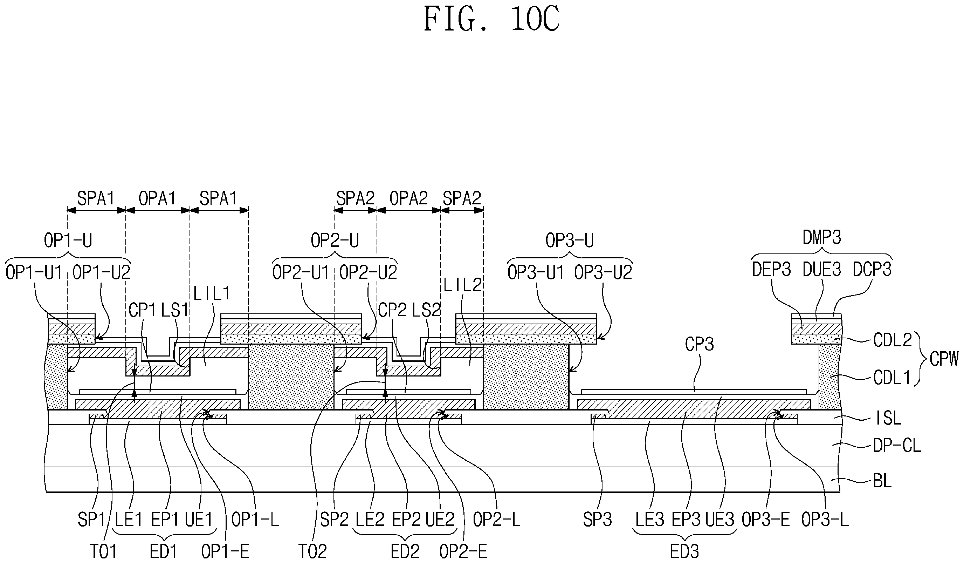

Referring to FIG. 10C, a third light-emitting element ED3 may be formed by sequentially stacking a third light-emitting pattern EP3, a third upper electrode UE3, and a third capping pattern CP3 in the third upper opening OP3-U. A third dummy pattern DMP3 may be formed by sequentially stacking a dummy third light-emitting pattern DEP3, a dummy third upper electrode DUE3, and a dummy third capping layer DCP3 on the upper surface of the second conductive layer CDL2. Since this may be performed in the same process as the process described in FIGS. 8G and 8H, a detailed description thereof will be omitted.

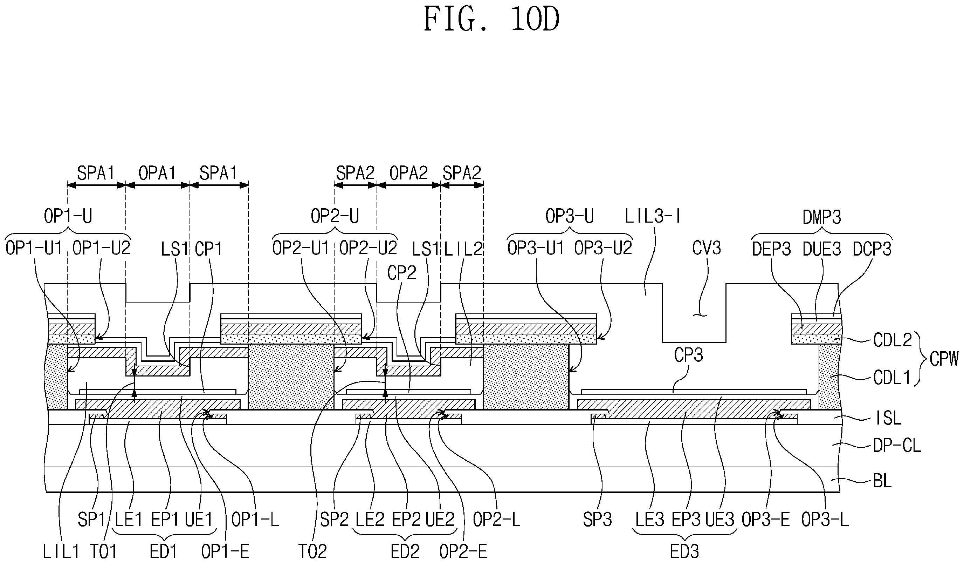

Referring to FIG. 10D, a third inorganic encapsulation layer LIL3-I overlapping the light-emitting regions PXA-R, PXA-G, and PXA-B (see FIG. 5B) and the non-light-emitting region NPXA (see FIG. 5B) may be formed on the third upper electrode UE3, the third capping pattern CP3, and the third dummy pattern DMP3 (see FIG. 5B). A third cavity CV3 overlapping the third light-emitting region PXA-B (see FIG. 5B) may be defined in the third inorganic encapsulation layer LIL3-I. The third cavity CV3 may have a shape corresponding to the third upper opening OP3-U. The third cavity CV3 may be a concave portion recessed toward the base layer BL. The third cavity CV3 may correspond to the third central portion OPA3 (see FIG. 5B). The third inorganic encapsulation layer LIL3-I may be formed through a chemical vapor deposition (CVD) process.

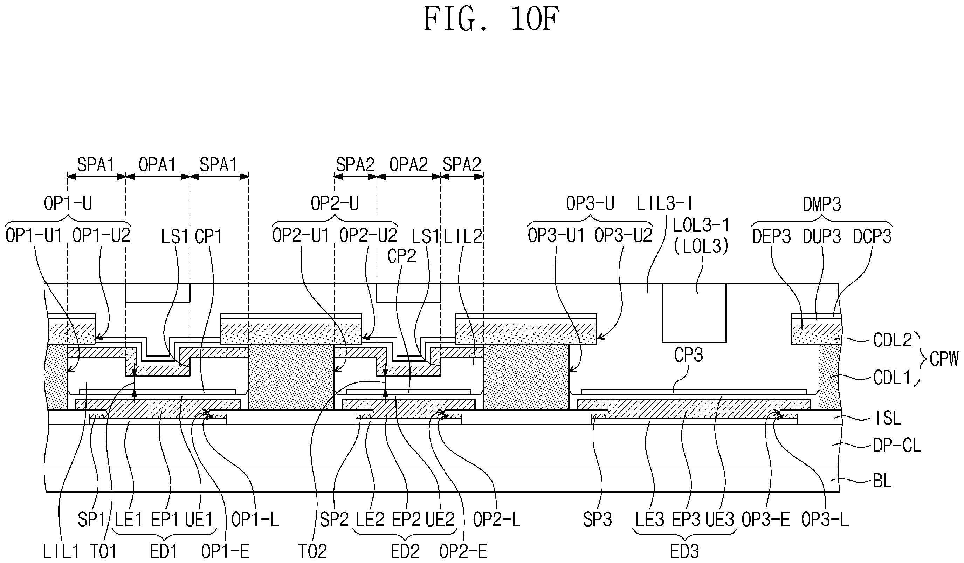

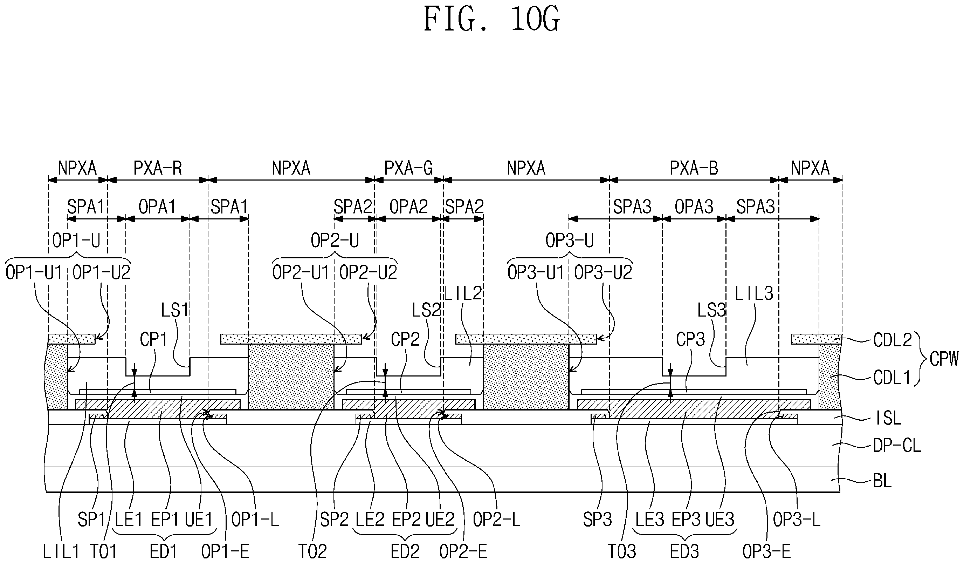

Referring to FIG. 10E, a third organic layer LOL3 may be formed on the third inorganic encapsulation layer LIL3-I. The third organic layer LOL3 may include a third filling portion LOL3-1 disposed in the third cavity CV3 and a third flat portion LOL3-2 having a flat upper surface. The third organic layer LOL3 may serve to protect the third light-emitting element ED3 from being damaged despite subsequent ashing and dry etching processes of FIGS. 10F and 10G.

Referring to FIGS. 10F and 10G, the third flat portion LOL3-2 (see FIG. 10E) of the third organic layer LOL3 may be removed. The third flat portion LOL3-2 may be removed by an ashing method. A third inorganic encapsulation pattern LIL3 may be formed in the third upper opening OP3-U by removing at least a portion of the third filling portion LOL3-1 and a portion of the third inorganic encapsulation layer LIL3-I. The third dummy pattern DMP3 including the dummy third light-emitting pattern DEP3, the dummy third upper electrode DUE3, and the dummy third capping layer DCP3 may be removed. The forming of the third inorganic encapsulation pattern LIL3 and the removing of the third dummy pattern DMP3 may be performed by a dry etching process.

At this time, in a region (hereinafter referred to as a third etching region) corresponding to the second light-emitting region PXA-G (see FIG. 5B) in FIG. 10F, the sequentially stacked dummy third light-emitting pattern DEP3, dummy third upper electrode DUE3, dummy third capping layer DCP3, third inorganic encapsulation layer LIL3-I, and third filling portion LOL3-1 may be etched. In a region (hereinafter referred to as a fourth etching region) corresponding to the third light-emitting region PXA-B (see FIG. 5B) in FIG. 10F, the sequentially stacked third inorganic encapsulation layer LIL3-I and third filling portion LOL3-1 may be etched. The height of the third filling portion LOL3-1 positioned in the third etching region may be smaller than that of the third filling portion LOL3-1 positioned in the fourth etching region.

Accordingly, a stacked structure etched in the third etching region and a stacked structure etched in the fourth etching region may be different from each other. Since different materials have different etch rates, the etch rates in the third etching region and the fourth etching region may be different from each other during an etching process. Accordingly, as illustrated in FIG. 10G, the thickness TO2 of the second inorganic encapsulation pattern LIL2 and a thickness TO3 of the third inorganic encapsulation pattern LIL3 may be different although the etching may be performed through a same process.

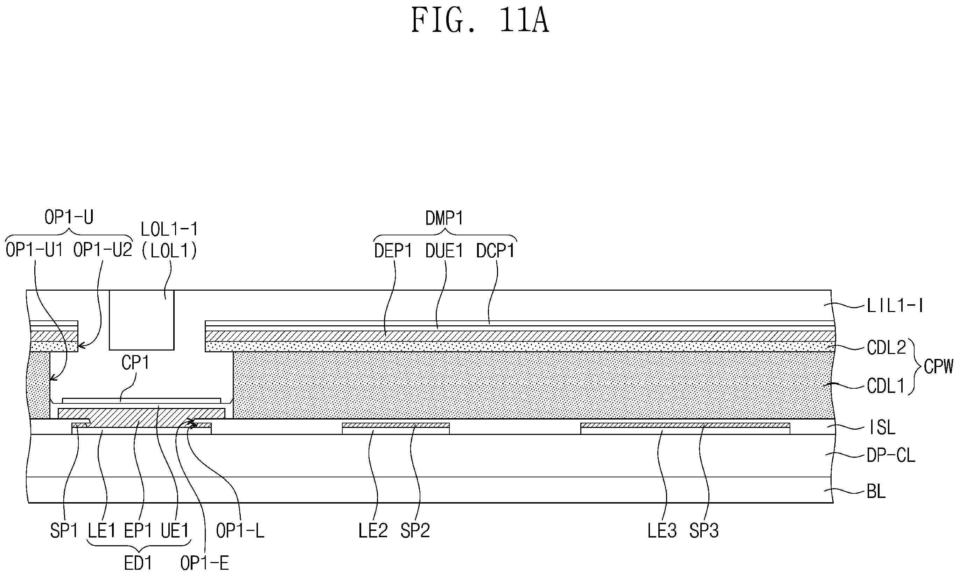

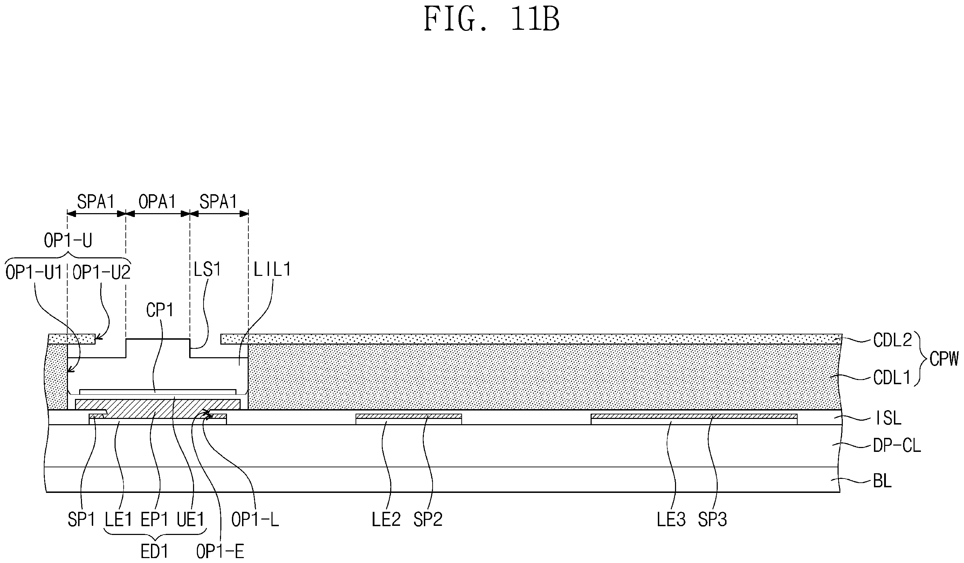

FIGS. 11A and 11B are schematic cross-sectional views illustrating some steps of the method of manufacturing the display device DD (see FIG. 1B) according to an embodiment. As the process of FIGS. 11A and 11B is the same as the process described with reference to FIGS. 8K and 8L except for the shape of the first central portion OPA1, a detailed description of the same process will be omitted.

Referring to FIGS. 11A and 11B, by removing at least a portion of the first filling portion LOL1-1 and a portion of the first inorganic encapsulation layer LIL-1-I, the first inorganic encapsulation pattern LIL1 may be formed in the first upper opening OP1-U. The first dummy pattern DMP1 including the dummy first light-emitting pattern DEP1, the dummy first upper electrode DUE1, and the dummy first capping layer DCP1 may be removed.

In a dry etching process, the etch rates of the first inorganic encapsulation layer LIL1-I and the first organic layer LOL1 may be different from each other. The etch rate of the first organic layer LOL1 according to an embodiment may be lower than the etch rate of the first inorganic encapsulation layer LIL1-I. Accordingly, the first organic layer LOL1 corresponding to the first central portion OPA1 may be etched more slowly than the first organic layer LOL1 corresponding to the first peripheral portion SPA1. Accordingly, the first central portion OPA1 may have a shape protruding toward the outside. The first central portion OPA1 may be closer to the second conductive layer CDL2 than the first peripheral portion SPA1.

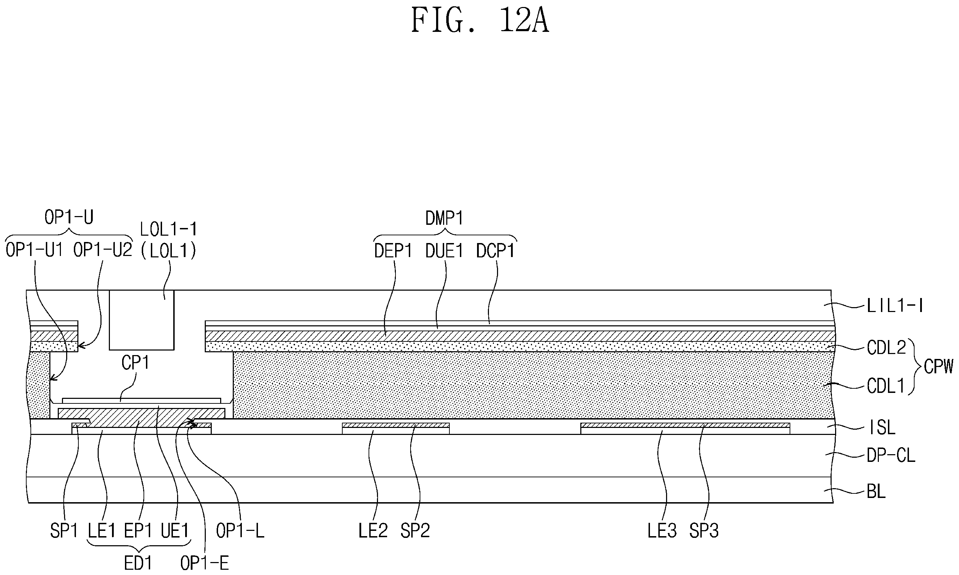

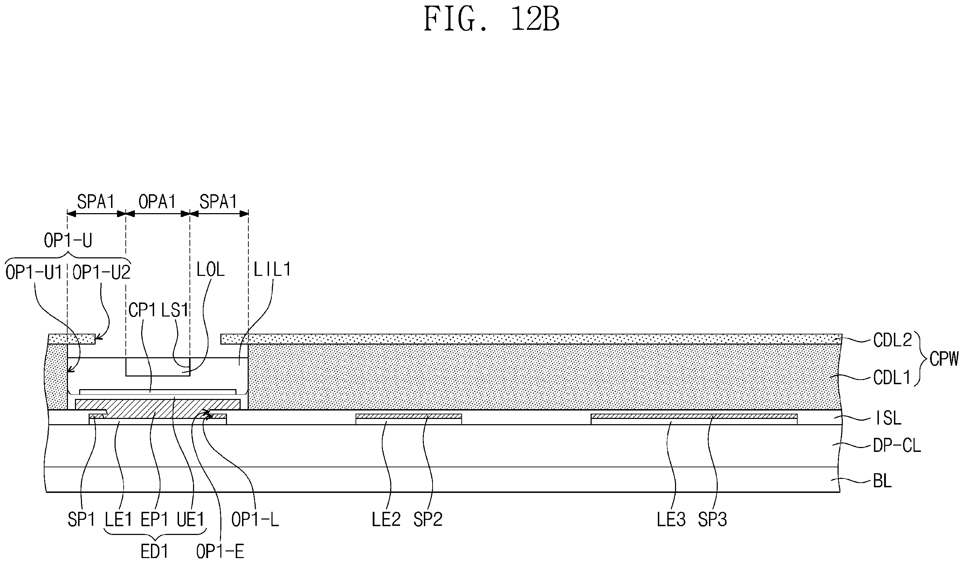

FIGS. 12A and 12B are schematic cross-sectional views illustrating some steps of the method of manufacturing the display device DD (see FIG. 1B) according to an embodiment.

Referring to FIGS. 12A and 12B, by removing at least a portion of the first filling portion LOL1-1 and a portion of the first inorganic encapsulation layer LIL-1-I, the first inorganic encapsulation pattern LIL1 may be formed in the first upper opening OP1-U. The first dummy pattern DMP1 including the dummy first light-emitting pattern DEP1, the dummy first upper electrode DUE1, and the dummy first capping layer DCP1 may be removed.

In a dry etching process, the etch rates of the first inorganic encapsulation layer LIL1-I and the first organic layer LOL1 may be the same as each other. Accordingly, the first organic layer LOL1 corresponding to the first central portion OPA1 and the first organic layer LOL1 corresponding to the first peripheral portion SPA1 may be etched at a same rate. The upper surface of the organic pattern LOL and the upper surface of the first inorganic encapsulation pattern LIL1 may be continuously connected to each other without a step difference. The organic pattern LOL may fill the recessed portion of the first central portion OPA 1.

According to the disclosure, it may be possible to prevent a display device from being damaged due to a contact of a mask by patterning a light-emitting pattern for each pixel without using a separate mask. Through this, it may be possible to provide a display device with improved reliability.

According to the disclosure, since a separate mask for patterning the light-emitting pattern may not need to be manufactured, it is also possible to provide a display device with a simplified process and reduced process costs.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure.

## Claims

1. A display device, comprising:
a base layer comprising:
a light-emitting region; and
a non-light-emitting region;
a first lower electrode disposed on the base layer;
an insulating film disposed on the base layer and including a first light-emitting opening and exposing at least a portion of an upper surface of the first lower electrode;
a conductive barrier rib disposed on the insulating film and having a first opening defined therein and corresponding to the light-emitting region;
a first light-emitting pattern disposed on the first lower electrode and disposed inside the first opening;
a first upper electrode disposed on the first light-emitting pattern and contacting an inner side surface of the conductive barrier rib defining the first opening; and
a first inorganic encapsulation pattern covering the first upper electrode, disposed in the first opening, and contacting the inner side surface of the conductive barrier rib defining the first opening,
wherein a central portion of an upper surface of the first inorganic encapsulation pattern and a peripheral portion surrounding the central portion of the upper surface of the first inorganic encapsulation pattern form a step difference.

2. The display device of claim 1, wherein:
(i) the central portion is recessed toward the base layer; or
(ii) the central portion protrudes toward an outside of the display device.

3. The display device of claim 1 or claim 2, further comprising:
a sacrificial pattern disposed on an outer side region of the first lower electrode and disposed between the first lower electrode and the insulating film.

4. The display device of any one of claims 1 to 3, wherein
the conductive barrier rib comprises:
a first conductive layer having a first conductivity; and
a second conductive layer disposed on the first conductive layer and having a second conductivity lower than the first conductivity, and
a thickness of the first conductive layer is greater than a thickness of the second conductive layer, optionally wherein:
an inner side surface of the first conductive layer defines a first region of the first opening;
an inner side surface of the second conductive layer defines a second region of the first opening,
in a cross sectional view, the inner side surface of the second conductive layer defining the second region is closer to a center of the first lower electrode than the inner side surface of the first conductive layer defining the first region.

5. The display device of claim 1 or claim 2, further comprising:
an organic pattern disposed on the first inorganic encapsulation pattern, overlapping the central portion in a plan view, and non-overlapping the peripheral portion in a plan view, optionally further comprising:
an organic encapsulation film disposed on the first inorganic encapsulation pattern and the organic pattern,
wherein the organic encapsulation film comprises a material different from a material of the organic pattern.

6. The display device of any one of claims 1 to 5, further comprising:
a second lower electrode disposed on a same layer as a layer on which the first lower electrode is disposed and spaced apart from the first lower electrode;
a second light-emitting pattern disposed on the second lower electrode and spaced apart from the first light-emitting pattern;
a second upper electrode disposed on the second light-emitting pattern and spaced apart from the first upper electrode; and
a second inorganic encapsulation pattern covering the second upper electrode and spaced apart from the first inorganic encapsulation pattern, wherein
a second light-emitting opening exposing a portion of an upper surface of the second lower electrode is defined in the insulating film;
a second opening spaced apart from the first opening is defined in the conductive barrier rib;
the second light-emitting pattern is disposed in the second opening;
the second upper electrode is disposed in the second opening and contacts an inner side surface of the conductive barrier rib defining the second opening; and
the second inorganic encapsulation pattern is disposed in the second opening and contacts the inner side surface of the conductive barrier rib defining the second opening, optionally wherein a minimum thickness of the first inorganic encapsulation pattern is greater than a minimum thickness of the second inorganic encapsulation pattern.

7. A method for manufacturing a display device, the method comprising:
providing a preliminary display panel comprising a base layer comprising a light-emitting region and a non-light-emitting region, a first lower electrode, an insulating film, and a conductive barrier rib including a first opening;
forming a first light-emitting pattern disposed on the first lower electrode inside the first opening and a dummy first light-emitting pattern disposed on an upper surface of the conductive barrier rib;
forming a first upper electrode disposed on the first light-emitting pattern and disposed inside the first opening and contacting an inner side surface of the conductive barrier rib defining the first opening and a dummy first upper electrode disposed on the dummy first light-emitting pattern;
forming a first inorganic encapsulation layer covering the first upper electrode and the dummy first upper electrode, overlapping the light-emitting region and the non-light-emitting region in a plan view, and defining a first cavity in the light-emitting region;
forming a first organic layer comprising a first filling portion disposed in the first cavity and a first flat portion disposed on the first inorganic encapsulation layer;
removing the first flat portion;
forming a first inorganic encapsulation pattern in the first opening by removing at least a portion of the first filling portion and at least a portion of the first inorganic encapsulation layer; and
removing the dummy first light-emitting pattern and the dummy first upper electrode.

8. The method of claim 7, wherein the forming of the first inorganic encapsulation pattern and the removing of the dummy first light-emitting pattern and the dummy first upper electrode are performed through a same etching step.

9. The method of claim 7 or claim 8, wherein:
(i) the removing of the first flat portion is performed by an ashing method; and/or
(ii) the forming of the first inorganic encapsulation pattern is performed by a dry etching method.

10. The method of any one of claims 7 to 9, wherein an etch rate of the first organic layer is higher than an etch rate of the first inorganic encapsulation layer.

11. The method of any one of claims 7 to 10, wherein the providing of the preliminary display panel comprises:
preparing the base layer, a first lower electrode disposed on the base layer, an insulating layer covering the first lower electrode, and a conductive barrier rib layer disposed on the insulating layer;
forming a preliminary first opening corresponding to the light-emitting region in the conductive barrier rib layer;
forming a first light-emitting opening exposing at least a portion of the upper surface of the first lower electrode in the insulating film; and
forming a first opening from the preliminary first opening of the conductive barrier rib layer so that a conductive barrier rib is formed from the conductive barrier rib layer.

12. The method of claim 11, wherein
the conductive barrier rib layer comprises:
a first conductive layer having a first conductivity; and
a second conductive layer disposed on the first conductive layer and having a second conductivity lower than the first conductivity,
the first conductive layer and the second conductive layer are dry-etched in the forming of the preliminary first opening;
the first conductive layer and the second conductive layer are wet-etched in the forming of the first opening; and
in a cross sectional view, the inner side surface of the second conductive layer defining a second region of the first opening is closer to a center of the first lower electrode than the inner side surface of the first conductive layer defining a first region of the first opening.

13. The method of claim 11 or claim 12, wherein
the preliminary display panel further comprises a sacrificial pattern disposed on the first lower electrode in the providing of the preliminary display panel; and
a lower opening exposing a portion of the upper surface of the first lower electrode is formed in the sacrificial pattern in the forming of the first opening.

14. The method of any one of claims 7 to 13, wherein a central portion of an upper surface of the first inorganic encapsulation pattern and a peripheral portion surrounding the central portion of the upper surface of the first inorganic encapsulation pattern form a step difference.

15. The method of any one of claims 7 to 14, wherein
the preliminary display panel further comprises a second lower electrode spaced apart from the first lower electrode;
a second opening is defined in the conductive barrier rib; and
the method further comprises:
forming a second light-emitting pattern disposed on the second lower electrode inside the second opening and a dummy second light-emitting pattern disposed on an upper surface of the conductive barrier rib inside the first opening;
forming a second upper electrode disposed on the second light-emitting pattern inside the second opening and contacting the inner side surface of the conductive barrier rib defining the second opening and a dummy second upper electrode disposed on the dummy second light-emitting pattern;
forming a second inorganic encapsulation layer covering the second upper electrode and the dummy second upper electrode, overlapping the light-emitting region and the non-light-emitting region in a plan view, and defining a second cavity in the light-emitting region;
forming a second organic layer comprising a second filling portion disposed in the second cavity and a second flat portion disposed on the second inorganic encapsulation layer;
removing the second flat portion;
forming a second inorganic encapsulation pattern in the second opening by removing at least a portion of the second filling portion and a portion of the second inorganic encapsulation layer; and
removing the dummy second light-emitting pattern and the dummy second upper electrode.
